# EUROPÄISCHE PATENTSCHRIFT

(11) **EP 4 402 539 B1**
(45) Veröffentlichungstag und Bekanntmachung des Hinweises auf die Patenterteilung: **30.09.2026**
(21) Anmeldenummer: 22765108.0
(22) Anmeldetag: 16.08.2022
(51) Int. Cl.: G03F 7/20, G02B 7/00, G02B 7/182, G02B 5/08

(54) **OPTISCHES ELEMENT MIT KÜHLKANÄLEN UND OPTISCHE ANORDNUNG**
OPTICAL ELEMENT WITH COOLING CHANNELS, AND OPTICAL ARRANGEMENT
ÉLÉMENT OPTIQUE À CANAUX DE REFROIDISSEMENT ET ENSEMBLE OPTIQUE

(30) Priorität: 13.09.2021 DE 102021210093
(43) Veröffentlichungstag der Anmeldung: 24.07.2024
(73) Patentinhaber: Carl Zeiss SMT GmbH, 73447 Oberkochen (DE)
(72) Erfinder: EVA, Eric, 73434 Aalen (DE)
(74) Vertreter: Kohler Schmid Möbus Patentanwälte
(86) Internationale Anmeldenummer: PCT/EP2022/072843
(87) Internationale Veröffentlichungsnummer: WO 2023/036568

(56) Entgegenhaltungen:
- EP-B1- 3 044 174
- WO-A1-2021/115643

## Beschreibung

### Priorität der Anmeldung

Diese Anmeldung beansprucht die Priorität der deutschen Patentanmeldung DE 10 2021 210 093.7 vom 13. September 2021.

### Hintergrund der Erfindung

Die Erfindung betrifft ein optisches Element zur Reflexion von Strahlung, insbesondere zur Reflexion von EUV-Strahlung, umfassend: ein Substrat, das aus Quarzglas, insbesondere aus titandotiertem Quarzglas, oder aus einer Glaskeramik gebildet ist und das einen ersten Teilkörper und einen zweiten Teilkörper umfasst, die entlang einer Bondingfläche durch Heißbonden zusammengefügt sind, eine Mehrzahl von Kühlkanälen, die in dem Substrat im Bereich der Bondingfläche verlaufen und durch Stege voneinander getrennt sind, sowie eine reflektierende Beschichtung, die auf eine Oberfläche des ersten Teilkörpers aufgebracht ist. Die Erfindung betrifft auch eine optische Anordnung, insbesondere ein EUV-Lithographiesystem, das mindestens ein solches reflektierendes optisches Element umfasst.

In einem EUV-Lithographiesystem in Form einer EUV-Lithographieanlage werden reflektierende optische Elemente in Form von Spiegeln, insbesondere in Form von Spiegeln eines Projektionssystems, einer hohen Strahlungsleistung ausgesetzt, die zu einer Erwärmung der Spiegel und somit des Spiegelsubstrats führt. Die Erwärmung des Substrats führt zu Deformationen an der Oberfläche des Substrats, an der eine reflektierende Beschichtung aufgebracht ist (d.h. an der Spiegeloberfläche). Die Deformationen führen zu Bildfehlern, welche die Abbildungsqualität des Projektionssystems beeinträchtigen. Um diesem Problem zu begegnen, werden typischerweise für die EUV-Spiegel Substrate aus Materialien verwendet, die einen geringen thermischen Ausdehnungskoeffizienten aufweisen. Titandotiertes Quarzglas, welches z.B. unter dem Handelsnamen ULE^{®} von der Fa. Corning vertrieben wird, sowie bestimmte Glaskeramiken, z.B. Zerodur^{®}, weisen einen besonders niedrigen thermischen Ausdehnungskoeffizienten auf und eignen sich daher für die Herstellung von Substraten für EUV-Spiegel.

Zur Reduzierung der Temperatur der Spiegel ist es bekannt, Kühlkanäle in das Substrat einzubringen, die mit einem Kühlfluid durchströmt werden. Die Herstellung der Kühlkanäle erfordert typischerweise das Einbringen von Durchgangskanälen mit einer vom jeweiligen Spiegel abhängigen Geometrie in das Substrat. Bei der Bearbeitung des Substrats zum Herstellen der Kühlkanäle können Spannungen in dem Glasmaterial auftreten, die sich ebenfalls ungünstig auf die Form der Spiegeloberfläche auswirken können, da diese bei der abschließenden Formgebung des Spiegels, z.B. beim Fräsen bzw. Polieren der Spiegeloberfläche, zu unerwarteten Formänderungen führen können.

In der WO 2021/115643 A1 ist ein Spiegel in EUV-Lithographiesystemen mit im Substrat ausgebildeten Kühlkanälen offenbart.

In der WO2020/207741 A1 ist ein Verfahren zum Herstellen eines Glaskörpers mit einer Mehrzahl von Kühlkanälen beschrieben. Das Verfahren umfasst folgende Schritte: Bereitstellen eines ersten Teilkörpers und eines zweiten Teilkörpers des Glaskörpers, Bilden mindestens eines Kühlkanals durch insbesondere mechanisches Bearbeiten des Glasmaterials an einer Oberfläche des ersten Teilkörpers und/oder des zweiten Teilkörpers, sowie Herstellen des Glaskörpers durch Verbinden des ersten Teilkörpers mit dem zweiten Teilkörper an der bearbeiteten Oberfläche durch Hochtemperatur-Bonden.

Beim in der WO2020/207741 A1 beschriebenen Hochtemperatur-Bonden bzw. beim Heißbonden werden die beiden Teilkörper entlang einer Bondingfläche zusammengefügt und in der Regel auf eine Temperatur von mindestens ca. 1000°C oder darüber erhitzt. Die beiden Teilkörper verbinden sich hierbei entlang der Bondingfläche ohne die Verwendung eines Fügemittels. Beim Erhitzen auf niedrigere Temperaturen wird in der Regel nicht die erforderliche Haftfestigkeit der Teilkörper bzw. der Fügepartner erreicht. Beim Verbinden durch Heißbonden können die beiden Teilkörper entlang der späteren Bondingfläche zunächst aneinander angesprengt werden, bevor diese auf die für das Heißbonden benötigten Temperaturen aufgeheizt werden. Alternativ können die beiden Teilkörper getrennt voneinander aufgeheizt werden und diese werden erst bei hohen Temperaturen entlang der Bondingfläche miteinander in Kontakt gebracht.

Es ist beispielsweise aus dem Artikel "Properties and Structure of Vitreous Silica. II" von R. Brückner, Journal of Non-Crystalline Solids 5 (1971) 177-216 (nachfolgend: "Brückner II") bekannt, dass bei einer Hochtemperaturbehandlung eines Quarzglas-Körpers ab Temperaturen von ca. 700°C oder darüber OH-Gruppen aus dem Quarzglas-Körper ausdiffundieren. Dies hat eine Verringerung des OH-Gehalts des Quarzglases in einer Verarmungszone zur Folge, die sich ausgehend von den äußeren Oberflächen des Quarzglas-Körpers in einen oberflächennahen Volumenbereich erstreckt. Der oberflächennahe Volumenbereich, der die Verarmungszone bildet, kann sich bei einer lang andauernden Temperbehandlung mehrere Millimeter oder sogar Zentimeter in das Volumen des Quarzglas-Körpers hinein erstrecken und hat unter anderem eine Erhöhung des Brechungsindexes in dem oberflächennahen Volumenbereich relativ zu einem Volumenbereich zur Folge, der näher am Zentrum des Quarzglas-Körpers liegt.

Es ist ebenfalls bekannt, dass ein geringerer OH-Gehalt in Quarzglas generell zu einer höheren Viskosität bei gegebener Temperatur führt. Dies hat zur Folge, dass sich die Glasmatrix in einem Quarzglas mit einem geringen OH-Gehalt bei üblichen Temperprogrammen nicht so gut entspannen und dementsprechend die fiktive Temperatur nicht so tief eingestellt werden kann wie dies bei OHreicherem Quarzglas möglich ist. Beispielsweise ist aus der Firmen-Broschüre "https://www.corning.com/media/worldwide/csm/documents/HPFS_Product_Bro chure_All_Grades_2015_07_21.pdf" bekannt, dass trockene Quarzgläser mit Glascode 7979 oder 8655 mit einem OH-Gehalt von weniger als 1 ppm einen ca. 65 ppm höheren Brechungsindex bei einer Wellenlänge von 194 nm aufweisen als Gläser mit einem höheren OH-Gehalt, was sich aus der höheren fiktiven Temperatur und dem geringeren OH-Gehalt ergibt.

Bei titandotiertem Quarzglas gilt dies entsprechend und hat zur Folge, dass bei vergleichbarem Titangehalt und vergleichbarem Temperprogramm die Nulldurchgangstemperatur des Quarzglas-Materials und die Steigung des thermischen Ausdehnungskoeffizienten in Abhängigkeit von der Temperatur bei einem OH-ärmeren Quarzglas auf einem höheren Niveau verbleiben als bei einem OH-reicheren Quarzglas. Zudem existiert eine direkte Abhängigkeit zwischen dem OH-Gehalt des (titandotierten) Quarzglases auf den thermischen Ausdehnungskoeffizienten sowie auf die Nulldurchgangstemperatur, wobei die direkte Abhängigkeit typischerweise überwiegt.

Der Einfluss des OH-Gehalts auf die Eigenschaften von Quarzglas wurde u.a. in dem Artikel "Der strukturmodifizierende Einfluss des Hydroxylgehaltes in Kieselgläsern" von Rolf Brückner, Glastechn. Berichte, Seite 8ff., 1970, sowie in dem Artikel "Der Einfluss des Hydroxylgehaltes auf die Dichte und auf den Diffusionsmechanismus in Kieselgläsern" von Rolf Brückner, Glastechn. Berichte, Seite 193ff., April 1965 untersucht. Diffusionskonstanten u.a. für die Diffusion von OH-Gruppen in Quarzglas sind in dem Artikel "Properties and Structure of Vitreous Silica. I" von R. Brückner, Journal of Non-Crystalline Solids 5 (1970) 123-175 (nachfolgend : "Brückner I") bzw. in dem Artikel "Brückner II" angegeben.

In der US 10,732,519 B2 ist ein Substrat für einen EUV-Spiegel beschrieben, der ein Profil der Nulldurchgangstemperatur aufweist, das von einer statistischen Verteilung abweicht. Das Profil der Nulldurchgangstemperatur ist an eine Betriebstemperatur des Spiegels angepasst. Bei dem Material des Substrats handelt es sich um titandotiertes Quarzglas, das in einem Soot-Prozess hergestellt wurde. Das Profil der Nulldurchgangstemperatur und das Profil des OH-Gehalts sind voneinander abhängig bzw. diese entsprechen einander. In einem Ausführungsbeispiel führt ein Absenken des OH-Gehalts von 200 Gew.-ppm auf 170 Gew.-ppm zu einer Veränderung der Nulldurchgangstemperatur, die in der Größenordnung von ca. 1 K liegt. Die fiktive Temperatur hängt ebenfalls vom OH-Gehalt ab und liegt bei einem Quarzglas mit einem OH-Gehalt von 180 Gew.-ppm im Volumen des Quarzglases bei einem Temperprozess mit einer Kühlrate von 4 K/h bei ca. 970 °C.

In der EP 3 044 174 B1 ist ein Verfahren zum Entspannen bzw. Tempern eines Siliziumdioxid-Titandioxid-Glases bekannt geworden. Das Temperverfahren soll eine unabhängige Einstellung der Nulldurchgangstemperatur und der Steigung der temperaturabhängigen Kurve des thermischen Ausdehnungskoeffizienten ermöglichen. In der EP 3 044 174 B1 ist beschrieben, dass für ein Quarzglas mit einem OH-Gehalt von ca. 850 Gew.-ppm im Volumen des Quarzglases und einer Kühlrate bei dem Temperprozess von ca. 3 K/h die fiktive Temperatur bei weniger als ca. 950°C liegt.

In der EP 3 110 766 B1 ist ein Verfahren zum Bilden eines Nulldurchgangstemperatur-Gradienten in einem Siliziumdioxid-Titandioxid-Glasartikel beschrieben, bei dem ein thermischer Gradient durch den Glasartikel gebildet wird und das Abkühlen des Glasartikels bei einer vorbestimmten Abkühlungsrate erfolgt, um den Nulldurchgangstemperatur-Gradienten durch die Dicke des Glasartikels zu formen.

Wie weiter oben beschrieben wurde, bilden sich bei einer Hochtemperaturbehandlung bzw. bei einem Temperprozess am Rand eines (titandotierten) Quarzglaskörpers Verarmungszonen aus, an denen der OH-Gehalt geringer ist als im Volumen, in dem ein (maximaler) OH-Gehalt in der Größenordnung von typischerweise ca. 850 Gew.-ppm bei einem direkt abgeschiedenen Glas (vgl. die EP 3 044 174 B1) bzw. ein (maximaler) OH-Gehalt in der Größenordnung von ca. 180 Gew.-ppm bei einem durch einen Soot-Prozess hergestellten Glas auftritt (vgl. die US 10,732,519). Die Dicke der Verarmungszone am Rand des Quarzglases kann beispielsweise beschrieben werden durch denjenigen Abstand vom Rand bzw. von der äußeren Oberfläche, bei dem der OH-Gehalt auf einen bestimmten Prozentsatz, z.B. 50%, des maximalen OH-Gehalts abgefallen ist oder bei dem der OH-Gehalt um einen bestimmten absoluten Wert vom maximalen OH-Gehalt abweicht. Die Dicke der Verarmungszone hängt u.a. von der Haltetemperatur, von der Haltedauer und von den Heiz- bzw. Kühlrampen des Temperprozesses sowie von der Zusammensetzung der Atmosphäre des Temperofens und des Werkstücks ab und kann wie weiter oben beschrieben einige 10 µm bis einige Millimeter betragen.

Für den Fall, dass das Material des Substrats Wasserstoff enthält, wie dies bei der Direktabscheidung und auch bei einem Homogenisierungsprozess in einer Knallgasflamme in der Regel der Fall ist, tritt in der Verarmungszone zusätzlich eine Wasserstoff-Verarmung auf, die schneller voranschreitet als die an OH-Gruppen. Wird der Temperprozess in einer reduzierenden Atmosphäre durchgeführt, kann dies zudem zu einem Verlust an Sauerstoff führen, was sich in der Ausbildung von Sauerstoff-Defektzentren ("oxygen deficient centers" = Si- bzw. Si-Ti-Bindungen) oder der Reduktion von Ti⁴⁺ zu Ti³⁺ äußert. Zudem kann Natrium aus Prozessmitteln in das Quarzglas eindiffundieren, was einen Einfluss auf den thermischen Ausdehnungskoeffizienten haben kann.

### Aufgabe der Erfindung

Aufgabe der Erfindung ist es, im Betrieb des optischen Elements auftretende Bildfehler zu reduzieren, die auf einen durch das Heißbonden verursachten Gradienten des OH-Gehalts zurückzuführen sind.

### Gegenstand der Erfindung

Diese Aufgabe wird gelöst durch ein optisches Element der eingangs genannten Art, bei dem ein jeweiliger Kühlkanal eine Kanalwand aufweist, die an mindestens einer an einen jeweiligen Steg angrenzenden Position, insbesondere in einem gesamten an den jeweiligen Steg angrenzenden seitlichen Wandabschnitt, eine Nulldurchgangstemperatur aufweist, die um weniger als 3,0 K, bevorzugt um weniger als 2,0 K, insbesondere um weniger als 1,0 K von einer Nulldurchgangstemperatur an einer Stegmitte des Stegs abweicht.

Der Vergleich zwischen der Nulldurchgangstemperatur an der an den jeweiligen Steg angrenzenden Position der Kanalwand und der Nulldurchgangstemperatur an der Stegmitte erfolgt in lateraler Richtung, d.h. in einer Ebene, die senkrecht zur Dickenrichtung des Substrats verläuft. Es versteht sich, dass ein an den Steg angrenzender seitlicher Kanalwandabschnitt typischerweise nicht nur an einer einzigen an einen jeweiligen Steg angrenzenden Position eine Nulldurchgangstemperatur aufweist, die um weniger als den oben angegebenen Wert von der Nulldurchgangstemperatur an der Stegmitte des Steges abweicht. Insbesondere kann die oben angegebene Bedingung entlang des gesamten seitlichen Wandabschnitts, d.h. an allen Positionen des seitlichen Wandabschnitts, erfüllt sein. Für die Reduzierung von Bildfehlern kann es aber ausreichend sein, wenn die obige Bedingung nur entlang eines Teils des seitlichen Wandabschnitts erfüllt ist. Insbesondere ist es nicht zwingend notwendig, dass an Eckbereichen, an denen der seitliche Wandabschnitt an einen oberen und einen unteren Wandabschnitt der Kanalwand angrenzt, die obige Bedingung an die Nulldurchgangstemperatur erfüllt ist.

Bei einer Ausführungsform weist die Kanalwand an mindestens einer der Oberfläche, auf welche die reflektierende Beschichtung aufgebracht ist, zugewandten Position, insbesondere in einem gesamten der Oberfläche zugewandten oberen Wandabschnitt eine Nulldurchgangstemperatur auf, die um weniger als 3,0 K, bevorzugt um weniger als 2,0 K, insbesondere um weniger als 1,0 K von einer Nulldurchgangstemperatur an der Oberfläche abweicht.

Da die Dicke des ersten Teilkörpers zwischen dem oberen Wandabschnitt des Kühlkanals und der Oberfläche in lateraler Richtung typischerweise variiert, erfolgt der Vergleich zwischen der Nulldurchgangstemperatur an der jeweiligen Position des oberen Wandabschnitts der Kanalwand mit der Nulldurchgangstemperatur an der Oberfläche an ein- und derselben lateralen Position.

Es versteht sich, dass der obere Kanalwandabschnitt typischerweise nicht nur an einer einzigen Position eine Nulldurchgangstemperatur aufweist, die um weniger als den oben angegebenen Wert von der Nulldurchgangstemperatur an der Oberfläche abweicht, auf welche die reflektierende Beschichtung aufgebracht ist. Insbesondere kann die oben angegebene Bedingung entlang des gesamten oberen Wandabschnitts, d.h. an allen Positionen des oberen Wandabschnitts, erfüllt sein. Für die Reduzierung von Bildfehlern kann es ausreichend sein, wenn die obige Bedingung nur entlang eines Teils des oberen Wandabschnitts erfüllt ist. Insbesondere ist es nicht zwingend notwendig, dass an Eckbereichen, an denen der obere Wandabschnitt an einen jeweiligen seitlichen Wandabschnitt der Kanalwand angrenzt, die obige Bedingung an die Nulldurchgangstemperatur erfüllt ist.

Wie weiter oben beschrieben wurde, führt das Heißbonden zu einer OH-Verarmung des Glasmaterials des Substrats in der Nähe aller äußeren Oberflächen des beim Heißbonden zusammengefügten Glaskörpers und somit auch an der Kanalwand eines jeweiligen Kühlkanals. Der Erfinder hat erkannt, dass das bei der Ausdiffusion der OH-Gruppen erzeugte Konzentrationsgefälle in der Nähe der Kanalwand die Nulldurchgangstemperatur des thermischen Ausdehnungskoeffizienten des Substrats so stark beeinflusst, dass die Spiegeloberfläche deformiert wird und Bildfehler im Betrieb des optischen Elements auftreten.

Ob das Substrat aufgrund des OH-Konzentrationsgefälles an der Kanalwand eine höhere oder eine geringere Nulldurchgangstemperatur als das ungestörte Glas im Inneren des Glaskörpers ausbildet, kann ggf. durch das Temperprogramm beeinflusst werden. Aufgrund des Konzentrationsgefälles ist es praktisch unmöglich, ein Temperprogramm zu wählen, bei dem sich für das ungestörte Glas und alle vorkommenden OH-Konzentrationen das gleiche Verhalten des thermischen Ausdehnungskoeffizienten und der Nulldurchgangstemperatur einstellt.

Der OH-Mangel führt auch dazu, dass sich bei gleichem Temperprogramm eine höhere fiktive Temperatur und somit eine größere Steigung des thermischen Ausdehnungskoeffizienten in Abhängigkeit von der Temperatur an bzw. in der Nähe der Kanalwand ausbildet. Bei einer Erwärmung des Spiegels durch eine lokale Wärmelast im Betrieb des Spiegels werden sich also OH-arme Bereiche umso mehr in ihrer Ausdehnung vom umgebenden Material unterscheiden, je stärker die Erwärmung ist. Dieses nichtlineare Verhalten als Funktion des Wärmeeintrags kann besondere Herausforderungen an die Kompensation der entstehenden Bildfehler stellen, zumal diese quadratisch mit der Temperaturdifferenz bzw. mit der Erwärmung zunehmen. Hierbei ist zu beachten, dass generell die Auswirkung der OH-Verarmung umso größer ist, je größer die Betriebstemperatur ist, da übliche Polier- und Messverfahren bei Raumtemperatur (22°C) durchgeführt werden. Aufwölbungen oder Grabenbildungen über den Kühlkanälen werden daher bei Raumtemperatur auskorrigiert und treten erst bei einer Betriebstemperatur wieder auf, die sich deutlich von der Raumtemperatur unterscheidet.

Abhängig vom verwendeten Temperprogramm und der lokalen Temperatur relativ zur durchschnittlichen Nulldurchgangstemperatur des Substrats kommt es aufgrund der OH-Verarmung entweder zu umlaufenden Zugspannungen oder Druckspannungen. Hier sei angenommen, es stellten sich Druckspannungen ein. Die Verarmungszone hätte ohne Randbedingungen ("unconstrained") eine geringere Dichte als das umgebende Material. Dies bewirkt einerseits eine Ausdehnung des Glasmaterials in den Kühlkanal hinein, die nicht weiter störend ist, andererseits eine Aufwölbung der Oberfläche, auf welche die reflektierende Beschichtung aufgebracht ist, oberhalb der Kühlkanäle. Dies ist insbesondere störend, weil die Bearbeitung dieser Oberfläche im Allgemeinen nicht bei der späteren Betriebstemperatur des Spiegels erfolgen kann (s.o.), so dass bei der Korrektur kein vollständiger Abtrag dieser Aufwölbungen möglich ist. Da im Hinblick auf Festigkeit, Driftarmut der Fügeverbindung und Kontrollierbarkeit der Nulldurchgangstemperatur höhere Bondingtemperaturen und / oder längere Haltedauern vorzuziehen sind und die Diffusionskonstante für OH-Gruppen mit der Temperatur steigt (siehe Fig. 36 in "Brückner II"), wird dieser Effekt bei höheren Bondingtemperaturen noch relevanter werden.

Das Substrat des hier beschriebenen Spiegels weist einen vergleichsweise kleinen lateralen Gradienten der Nulldurchgangstemperatur sowie einen vergleichsweise kleinen Gradienten in Dickenrichtung des Substrats oberhalb des Kühlkanals auf, so dass die weiter oben beschriebene Aufwölbung der Oberfläche, auf welche die reflektierende Beschichtung aufgebracht ist, vergleichsweise gering ausfällt. In einem unteren Kanalwandabschnitt der Kanalwand ist die Auswirkung des Gradienten der Nulldurchgangstemperatur auf die Oberfläche typischerweise vergleichsweise gering, so dass dort in der Regel keine Bedingung an die Nulldurchgangstemperatur eingehalten werden muss.

Grundsätzlich ist es aber dennoch günstig, wenn der Kühlkanal entlang der gesamten Kanalwand eine Nulldurchgangstemperatur aufweist, die um weniger als 3,0 K, bevorzugt um weniger als 2,0 K, insbesondere um weniger als 1,0 K von einer mittleren Nulldurchgangstemperatur im Volumen des Substrats abweicht. Die Nulldurchgangstemperatur wird in diesem Fall über alle Positionen im Volumen des Substrats gemittelt, die in einem Abstand von weniger als 1 cm von der Oberfläche entfernt sind, auf welche die reflektierende Beschichtung aufgebracht ist. In lateraler Richtung erfolgt die Mittelung über alle Positionen im Volumen des Substrats, die sich in Dickenrichtung unterhalb eines optisch genutzten Bereichs der reflektierenden Beschichtung befinden sowie bis zu einem lateralen Abstand von 1 cm über den optisch genutzten Bereich der reflektierenden Beschichtung hinaus. Der optisch genutzte Bereich bezeichnet hierbei einen Teilbereich der reflektierenden Beschichtung, der ein Abbildungslicht nach Reflektion für eine weitere Verwendung nutzbar macht.

Wie weiter oben beschreiben wurde, wird die Nulldurchgangstemperatur wesentlich vom OH-Gehalt des Substrats beeinflusst, kann aber auch durch andere Effekte beeinflusst werden. Beispielsweise stellen sich ähnliche Konzentrationsprofile auch für einen Wasserstoff- oder Sauerstoffmangel ein bzw. inverse Profile für die Eindiffusion von Metallen, beispielsweise von Natrium. Insbesondere Natrium diffundiert besonders schnell, vgl. hierzu beispielsweise die US9382151B2.

Bei einem weiteren Aspekt der Erfindung, der insbesondere mit dem weiter oben beschriebenen Aspekt kombiniert werden kann, weist ein jeweiliger Kühlkanal eine Kanalwand auf, die an mindestens einer an einen jeweiligen Steg angrenzenden Position, insbesondere in einem gesamten an den jeweiligen Steg angrenzenden seitlichen Wandabschnitt, einen OH-Gehalt aufweist, der um nicht mehr als 60 Gew.-ppm, bevorzugt um nicht mehr als 30 Gew.-ppm, insbesondere um nicht mehr als 20 Gew.-ppm von einem OH-Gehalt an einer Stegmitte des jeweiligen Stegs abweicht.

Bei einer Ausführungsform dieses Aspekts der Erfindung weist die Kanalwand an mindestens einer der Oberfläche, auf welche die reflektierende Beschichtung aufgebracht ist, zugewandten Position, insbesondere in einem gesamten der Oberfläche zugewandten oberen Wandabschnitt, einen OH-Gehalt auf, der um nicht mehr als 60 Gew.-ppm, bevorzugt um nicht mehr als 30 Gew.-ppm, insbesondere um nicht mehr als 20 Gew.-ppm von einem OH-Gehalt an der Oberfläche abweicht.

Wie weiter oben beschrieben wurde, hat der OH-Gehalt des Glases einen wesentlichen Einfluss auf die Nulldurchgangstemperatur und somit auf die Deformationen, die bei der Betriebstemperatur an der Oberfläche des Spiegels auftreten. Durch die Einhaltung der hier beschriebenen Bedingungen an den OH-Gehalt in lateraler Richtung bzw. in Dickenrichtung lassen sich typischerweise die obigen Bedingungen für die Nulldurchgangstemperatur des Substrats in lateraler Richtung und in Dickenrichtung einhalten, sodass Bildfehler im Betrieb des optischen Elements deutlich reduziert werden können.

Es hat sich gezeigt, dass bereits geringe Unterschiede im OH-Gehalt des Quarzglases von z.B. 30 ppm zu einer Veränderung der Nulldurchgangstemperatur von ca. 1 K führen können, d.h. die Auswirkungen geringer Schwankungen des OH-Gehalts auf die Nulldurchgangstemperatur sind erheblich. Daher hat ein deutlicher Abfall des OH-Gehalts von einem maximalen Wert von z.B. 180 Gew.-ppm oder von 850 Gew.-ppm auf 0 Gew.-ppm drastische Auswirkungen auf die Nulldurchgangstemperatur, selbst wenn die Dicke des Verarmungsbereichs nur wenige Mikrometer beträgt.

Für den Fall, dass bei dem Heißbonding-Prozess die beiden Teilkörper separat erwärmt und erst bei erhöhter Temperatur zusammengeführt werden, kommt es typischerweise zusätzlich zu einer OH-Verarmung des Substrat-Materials beiderseits der Bondingfläche, an der die beiden Teilkörper zusammengefügt werden, da die Oberflächen der beiden Teilkörper, entlang derer die spätere Bondingfläche verläuft, vor dem Zusammenfügen OH-Gruppen verlieren. Die OH-Verarmung entlang der Bondingfläche ist jedoch weniger störend, da die OH-Inhomogenität bzw. die Inhomogenität des thermischen Ausdehnungskoeffizienten dort im Wesentlichen zu einer lateral konstanten Dickenänderung des Substrats führt. Zudem wird diese Inhomogenität nach dem Verbinden weitgehend ausgeglichen durch die Diffusion von OH-Gruppen aus dem Substrat in die Verarmungszone.

Bei einem Heißbonding-Prozess, bei dem ein Ansprengen der beiden Teilkörper vor dem Erwärmen erfolgt, ist hingegen mit einer erhöhten Konzentration von OH-Gruppen und über Wasserstoffbrückenbindungen gebundenem H₂O zu rechnen, die bei nachfolgenden Heißprozessen ins Material eindiffundieren könnte. Auch ist damit zu rechnen, dass diese zu einer Schicht mit einem abweichenden thermischen Ausdehnungskoeffizienten führt, die außer an den Rändern zu den Kühlkanälen, an denen es auch zu einem lateralen OH-Gefälle kommen kann, relativ geringen Einfluss hat.

Bei einer Weiterbildung weist die Kanalwand an der mindestens einen an den Steg angrenzenden Position, insbesondere im gesamten seitlichen Wandabschnitt, und/oder an der mindestens einen der Oberfläche zugewandten Position, insbesondere im gesamten oberen Wandabschnitt, einen OH-Gehalt auf, der größer als 0 Gew.-ppm, bevorzugt größer als 60 Gew.-ppm, insbesondere größer als 120 Gew.-ppm ist.

Der Heißbonding-Prozess findet typischerweise in einem Ofen statt, in dem die Umgebung des Glaskörpers, der beim Zusammenfügen der beiden Teilkörper gebildet wird, einen Wasserdampf-Dampfdruck aufweist, der gegen Null geht, da der Ofen mit Vakuum, Luft oder Inertgas mit ausreichender Umwälzung betrieben wird. Aufgrund der weiter oben beschriebenen Ausdiffusion von OH-Gruppen ohne Barrierewirkung gemäß "Brückner II" liegt der OH-Gehalt am der Kanalwand daher bei 0 Gew.-ppm, d.h. die Kanalwand hat einen verschwindend geringen OH-Gehalt. Um den OH-Gehalt an der Kanalwand zu erhöhen und somit den Gradienten des OH-Gehalts im Vergleich zum mittleren OH-Gehalt im Volumen des Substrats zu verringern, bestehen verschiedene Möglichkeiten, von denen nachfolgend mehrere beschrieben sind.

Um den OH-Gradienten zu verringern, kann beispielsweise Material des Substrats von den Kanalwänden der Kühlkanäle abgetragen werden. Die Dicke des abgetragenen Bereichs hängt von der Dicke des Verarmungsbereichs sowie davon ab, welcher OH-Gradient in dem Material des Substrats im Hinblick auf Bildfehler toleriert werden kann. Die Dicke des abgetragenen Bereichs hängt insbesondere auch davon ab, wie groß der mittlere bzw. der maximale OH-Gehalt des Substrats ist, da der Gradient des OH-Gehalts umso größer ist, je größer der maximale OH-Gehalt des Substrats ist.

Für das Abtragen des Materials bestehen verschiedene Möglichkeiten:
Die Kühlkanäle können nach dem Bonden beispielsweise mit einer abrasiven Emulsion oder einer Ätzlösung behandelt werden. Die Emulsion muss ohnehin unter Druck durchgespült werden. Auch bei der Ätzlösung empfiehlt sich ein regelmäßiger Austausch oder ein langsames Spülen, um ein Überätzen am Eingang und Ausgang eines jeweiligen Kühlkanals zu vermeiden. Jedoch führen beide Verfahren zu einer Aufrauhung der Innenseiten der Kanalwand und zu einem ungleichmäßigen Abtrag, beispielsweise in den ggf. vorhandenen gekrümmten Bereichen der Kanäle. Bei Verarmungsbereichen, die eine große Dicke aufweisen und einen Abtrag von 1 mm oder mehr notwendig machen würden, ist dieses Verfahren nicht mehr praktikabel.

Anstelle der üblichen Flusssäure kann auch heiße Phosphorsäure als Ätzlösung verwendet werden, die deutlich weniger giftig ist und langsamer ätzt. Dies bieten den Vorteil, dass die Kühlkanäle mit angeflanschten Schläuchen über einen längeren Zeitraum gespült werden können, was aus Arbeitsschutzgründen mit Flusssäure nicht möglich wäre. Ebenso kann die Ätzwirkung durch geeignete Vorschädigung beispielsweise mittels eines Kurzpulslasers räumlich gesteuert werden. Das Vorschädigen kann entweder vor dem Zusammenfügen der beiden Teilkörper in die offenliegenden Kühlkanäle bzw. in die eingefrästen Vertiefungen oder nach dem Heißbonden durch die Oberfläche hindurch erfolgen, auf welche später die reflektierende Beschichtung aufgebracht wird. Auch eine Steuerung des Ätzvorgangs in-situ durch eine Ultraschall-Behandlung ist möglich. Die Belichtung oder Beschallung durch die spätere Spiegeloberfläche hindurch erlauben einen verstärkten Abtrag vorzugsweise an der Oberseite des seitlichen Kanalwandabschnitts des Kühlkanals und im oberen Bereich der seitlichen Kanalwandabschnitte. Wie weiter oben beschreiben wurde, handelt es sich hierbei genau die Bereiche, an denen eine Inhomogenität des thermischen Ausdehnungskoeffizienten oder der Nulldurchgangstemperatur besonders störend sind. Die im Betrieb des Spiegels an der Spiegeloberfläche abgetragenen Wärmelasten führen zu einer maximalen Temperaturerhöhung an der Kanaloberseite bzw. am oberen Kanalwandabschnitt und zu einer stetigen Abnahme mit zunehmender Tiefe, so dass an der Kanalunterseite bzw. am unteren Kanalwandabschnitt kaum noch eine Temperaturerhöhung auftritt.

Insbesondere in Verbindung mit einer Vorschädigung können auch Laugen als Ätzmittel verwendet werden: Es ist bekannt, dass in Quarzglas durch Kurzpulslaservorschädigung eine Ätzrate von 300 µm/h bei 80°C warmer, 8 molarer KOH-Lauge mit Ultraschallunterstützung erreicht werden kann. Die Ätzselektivität ist dabei 1:1400, d.h. ohne eine Vorschädigung werden schlimmstenfalls nur 0,2 µm/h erreicht. Bei 100 µm Abtrag wären das drei Wochen, was eine tolerierbare Zeitdauer für den Abtrag darstellt, zumal titandotiertes Quarzglas ggf. eine geringfügig höhere Ätzrate aufweist. Alternativ könnte die Temperatur und die Konzentration der Lauge noch etwas erhöht werden, zumal der Siedepunkt einer konzentrierten Lauge deutlich über 100°C liegen dürfte (50%ige Natronlauge hat 143 °C, 45%ige Kalilauge 136°C). Bei Überschreiten des Siedepunktes wäre ein Druckbehälter notwendig, was jedoch nur den apparativen Aufwand erhöht. Es ist möglich, ohne die Anwendung einer Vorschädigung bei den Ätzparametern aggressiver vorzugehen, da ja gerade keine Ätzselektivität erzielt werden soll.

Es ist zudem durchaus wahrscheinlich, dass OH-verarmtes Quarzglas eine höhere Ätzrate hat als nicht verarmtes Quarzglas aufweist, da das OH als Matrixterminator wirkt, d.h. es gibt der Glasmatrix zusätzliche Freiheitsgrade, weil an einer Tetraederecke mit Terminator keine Vernetzung mit Nachbartetratedern unter Einhaltung der Bindungswinkel mehr erfolgen muss. Diffundiert OH aus, so ist es unwahrscheinlich, dass sich zwei Fehlstellen zu einer kovalenten Verbindung zusammenfinden können, also darf angenommen werden, dass diese Fehlstellen eine Vorschädigung darstellen. Für den Fall dass dies zutrifft, trägt sich die Verarmungszone weitgehend selbstgesteuert ab, d.h. unabhängig von eventuellen Strömungsverhältnissen bei aktiver Spülung mit Ätzlösung. Es ist möglich, dass in diesem Fall Säuren effektiver sind als Laugen, da Laugen das fehlende OH nachliefern. Andererseits liefern Säuren ein Proton, das ebenfalls als Matrixterminator wirken kann.

Generell ist beim Abtragen die Verwendung langsamer Ätzmittel (Phosphorsäure oder Lauge) von Vorteil, da bei geringer Ätzrate auch mit extrem geringen Strömungsgeschwindigkeiten gearbeitet werden kann und sich somit nicht das Problem ergibt, dass an Stellen hoher Strömungsgeschwindigkeit auch der höchste Ätzabtrag erfolgt.

Es ist auch möglich, gasförmige Ätzmedien zu verwenden, etwa das abgedampfte Gas von konzentrierter Flusssäure oder fluorhaltige organische Substanzen, wie sie zur Fluordotierung von Soot-Gläsern verwendet werden.

Es versteht sich, dass bei der Herstellung des Substrats aus dem durch das Heißbonden gebildeten Glaskörper typischerweise auch die Verarmungszone an der Oberfläche, an welcher die reflektierende Beschichtung aufgebracht wird, sowie an der gegenüberliegenden Oberfläche am Boden des Glaskörpers bzw. des zweiten Teilkörpers abgetragen wird. Die Oberfläche des ersten Teilkörpers, auf welche die reflektierende Beschichtung aufgebracht ist, und der Boden des zweiten Teilkörpers erlauben einen einfacheren Abtrag der Verarmungszone, da diese gut zugänglich sind. Jedoch muss gerade das Material des ersten Teilkörpers von allerhöchster Qualität hinsichtlich Homogenität und Blasenfreiheit sein. Ein Abtrag von etlichen Millimetern oder gar einigen Zentimetern stößt schnell an Grenzen, was die Kosten, aber auch die Herstellbarkeit von hochwertigen Glasblöcken entsprechenden Gewichts angeht.

Bei mechanischen Abtragsverfahren ist es neben dem Spülen mit einer abrasiven Emulsion auch möglich, rotierende Bürsten oder Schwämme in dem Kühlkanal einzuführen. Auch ist es möglich, trockene Schleifpartikel oder eine Schleifflüssigkeit mit möglichst großem Unterschied in der Dichte der Flüssigkeit und der Partikel einzubringen. Die Agitation der Partikel kann durch Ultraschall oder Vibrieren des gesamten Glaskörpers mittels eines Shakers erfolgen. Auch könnten ferromagnetische Partikel und ein externes Magnetfeld verwendet werden. Bei dem externen Feld kann es sich um ein Wechselfeld handeln, um die Partikel in Vibrationen zu versetzen. Es kann sich aber auch um ein quasistatisches, bewegliches Feld handeln, wobei die Vibration weiterhin durch einen Shaker erzeugt wird. Dies hätte den Vorteil, dass sich Ort und Richtung des Abtrags steuern ließen, also z.B. einem unerwünschten verstärkten Abtrag in Gebieten erhöhter Bewegungsgeschwindigkeit entgegengewirkt werden kann.

Ferner kann Abtrag durch Erzeugen von Kavitationsblasen in einer Flüssigkeit erzeugt werden, wobei die Blasen beispielsweise durch fokussierten Ultraschall, durch elektrische Entladungen oder Laserpulse erzeugt werden kann. Wenn die Flüssigkeit gleichzeitig ätzend wirkt, ist auf diese Weise ein lokal steuerbarer Abtrag möglich.

Bei einer weiteren Ausführungsform weist ein an die Kanalwand angrenzender Verarmungsbereich, an dem der OH-Gehalt des Substrats mindestens 5 Gew.-ppm kleiner ist als der OH-Gehalt an der Stegmitte des jeweiligen Stegs und/oder an der Oberfläche eine Dicke von weniger als 50 µm, bevorzugt von weniger als 30 µm, insbesondere von weniger als 1 µm auf. Wie weiter oben beschrieben wurde, kann die Dicke des Verarmungsbereichs reduziert werden, indem Material von den Kanalwänden abgetragen wird. Die Dicke des Materials, das abgetragen wird und auch die Dicke des Verarmungsbereichs hängt u.a. von der Steilheit des Gradienten des OH-Gehalts in dem Substrat ab.

Wie weiter oben beschrieben wurde, ist generell die OH-Verarmung umso störender, je größer der Unterschied zwischen der Betriebstemperatur des Spiegels und der Poliertemperatur ist, bei der die Aufwölbungen oder Grabenbildungen über den Kühlkanälen korrigiert werden (typischerweise 22°C). Eine größere Betriebstemperatur macht daher in der Regel einen größeren Abtrag erforderlich. Der tolerierbare Restabfall des OH-Gehalts in dem Verarmungsbereich ist daher umso geringer, je größer die Differenz zwischen der Poliertemperatur und der Betriebstemperatur ist. Bei einer Poliertemperatur von 22°C und einer Betriebstemperatur von 25°C kann es ausreichend sein, den Verarmungsbereich nur von 0 bis 20% des mittleren OH-Gehalts im Volumen des Substrats abzutragen, bei einer Betriebstemperatur von 35°C wäre ggf. ein Abtrag von 0 bis 90% des mittleren OH-Gehalts im Volumen des Substrats erforderlich. Im ersten Fall wäre die Dicke des Verarmungsbereichs, der nach dem Abtrag verbleibt, daher größer als im zweiten Fall. Die Dicke des abgetragenen Materials hängt auch vom absoluten Wert des OH-Gehalts im Inneren des Substrats ab. Bei einem maximalen OH-Gehalt des Substrats von ca. 200 Gew.-ppm ist es bei einer Betriebstemperatur von 25°C in der Regel ausreichend, wenn Material in einem Bereich zwischen 0 % und 20 % des maximalen OH-Gehalts abgetragen wird, für den Fall, dass der maximale OH-Gehalt bei 800 Gew.-ppm liegt, ist es typischerweise erforderlich, dass an der Kanalwand Material abgetragen wird, dessen OH-Gehalt zwischen 0 und 50 Gew.-% des maximalen OH-Gehalts liegt, d.h. es muss entsprechend mehr Material abgetragen werden.

Bei einer weiteren Ausführungsform weicht ein OH-Gehalt an der Kanalwand um weniger als 10 %, bevorzugt um weniger als 5 %, insbesondere um weniger als 1 % von einem mittleren OH-Gehalt im Volumen des Substrats (d.h. außerhalb der Kühlkanäle) ab.

Bei den weiter oben beschriebenen Ausführungsformen tritt in einem an die Kanalwand angrenzenden Volumenbereich eine OH-Verarmung auf, d.h. der OH-Gehalt ist gegenüber dem OH-Gehalt im Volumen des Substrats verringert. Es ist grundsätzlich aber auch möglich, dass der mittlere OH-Gehalt des Substrats in dem an die Kanalwand angrenzenden Bereich größer ist als der mittlere OH-Gehalt des Substrats. Dies kann der Fall sein, wenn das Heißbonden unter geeigneten Umgebungsbedingungen, insbesondere in gesättigtem Wasserdampf, durchgeführt wird und/oder wenn eine Nachbehandlung des Substrats bzw. des beim Heißbonden gebildeten Glaskörpers erfolgt. Hierbei ist zu beachten, dass auch eine Erhöhung des OH-Gehalts über den mittleren OH-Gehalt hinaus zu einem ungewollten OH-Gradienten führt, der vermieden werden sollte.

Der mittlere OH-Gehalt des Substrats bzw. des Substrat-Materials kann beispielsweise durch FTIR oder IR-Spektroskopie oder Ramanspektroskopie bestimmt werden. Der für den Heißbonding-Prozess bzw. für die Nachbehandlung ideale OH-Gehalt kann unter Kenntnis des Diffusionsfaktors berechnet und der Partialdruck des Wasserdampfs entsprechend eingestellt werden. Apparativ kann der korrekte Partialdruck durch eine Begrenzung der Wassereinspritzung, durch Zumischen von trockener Luft oder durch eine passende Absaugung, die Unterdruck erzeugt, erfolgen. Da das Diffusionsverhältnis bei geringeren Temperaturen sinkt, ist es typischerweise erforderlich, den Wasserdampf-Partialdruck in der Abkühlphase des Heißbonding-Prozesses entsprechend einer Vorausberechnung gegebenenfalls nachzuführen und zu senken. Durch das Heißbonden unter Wasserdampf bzw. die Nachbehandlung kann insbesondere bei in einem Soot-Prozess abgeschiedenen (titandotiertem) Quarzglas erreicht werden, dass der OH-Gehalt an der Kanalwand bzw. in einem an diese angrenzenden Bereich nur um weniger als ca. 10%, 5 % oder ggf. 1 % vom durchschnittlichen OH-Gehalt im Volumen des Substrats abweicht.

Gegen ein Heißbonden in Wasserdampf spricht grundsätzlich, dass auch die Ausdiffusion von Oberflächenwasser und Kondensationswasser bei der Umwandlung von über Wasserstoffbrücken gebundenen SiOH-Gruppen in Matrixbindungen Si-O-Si nicht mehr leicht lateral aus der Bondingfläche ausdiffundieren kann.

Gegen ein Nachbehandeln durch nachträgliches Auffüllen mit OH-Gruppen in Form einer Wärmebehandlung in gesättigtem Wasserdampf oder Wasser spricht, dass der Nachbehandlungs-Prozess mindestens so lange wie das ursprüngliche Heißbonden dauert und sich währenddessen andere Materialeigenschaften wie z.B. der thermische Ausdehnungskoeffizient verändern können. Zudem ist es in der Regel nicht ohne weiteres möglich, dabei genau das Mangelprofil des OH-Gehalts auszugleichen, zumal dessen messtechnische Erfassung auf einer Mikrometer-Skala nicht ohne weiteres möglich ist. Hinzu kommt, dass gemäß Fig. 36 und Abs. 5.1.3.2 des Artikels "Brückner II" die Ausdiffusion einen wesentlich höhere Diffusionskonstante als die Eindiffusion aufweist (s.o.), so dass ein solcher Prozess, der in der Regel bei geringerer Temperatur als das Bonden stattfinden muss, sehr zeitraubend ist. Auf jeden Fall sollte bei jeder Temperatur mit möglichst hohem Partialdruck des Wassers bzw. des Wasserdampfs gearbeitet werden, da die Löslichkeit mit dem Quadrat des Dampfdrucks steigt.

Es hat sich eine Kombination aus Auffüllen von OH-Gruppen und Heißbonden als günstig erwiesen, bei welcher die Zuführung von Wasserdampf verzögert erfolgt. In diesem Fall wird das Heißbonden zunächst trocken begonnen und es wird ein Halteschritt von mehreren Stunden oder Tagen bei 120°C bis 250°C für die Ausdiffusion des Oberflächenwassers und optional ein weiterer Halteschritt von mehreren Stunden bei 500 - 600°C zur Ausdiffusion des Kondenswassers eingelegt, bevor dann Wasserdampf zugegeben wird. Da die Ausdiffusionsraten bei den geringeren Temperaturen gemäß "Brückner II" noch moderat sind, kann das Auffüllen effizient beim ohnehin notwendigen Halteschritt des Heißbondens erfolgen. Die Ausdiffusion der OH-Gruppen kann daher typischerweise deutlich reduziert werden, wenn insbesondere die heißesten Temperschritte beim Heißbonden in möglichst gesättigtem Wasserdampf erfolgen.

Ist dies nicht praktikabel, sollte beim Heißbonden zumindest eine oxidierende Atmosphäre verwendet werden: An den Oberflächen der Teilkörper, an denen die Bondingfläche gebildet wird, kommen ungesättigte Si- bzw. Ti-Bindungen vor, ferner ungesättigte Si-O bzw. Ti-O-Bindungen, ferner die abgesättigten Formen SiH und TiH und Si-OH und Ti-OH, wobei die OH-Gruppen insbesondere bei Normalatmosphäre dominieren. Wenn die Oberflächen zuvor Raumluft ausgesetzt waren, werden also OH-Gruppen dominieren. Diese können nur zu Wasser werden, wenn ihnen Wasserstoff angeboten wird, der entweder aus dem Substrat bzw. aus dem Glaskörper diffundiert oder aus dem Ofen kommt. In oxidierender Atmosphäre wird solcher Wasserstoff direkt zu Wasserdampf oxidiert und kann sich daher nicht mehr mit einer OH-Gruppe verbinden. In reduzierender Atmosphäre kann Restwasser mit der Ofenwandung oder Hilfsmitteln wie Formen (die häufig aus Graphit bestehen) reagieren, was Wasserstoff freisetzt. Durch die oxidierende Atmosphäre wird also eine künstliche Austrittsbarriere für die OH-Gruppen an der Oberfläche geschaffen. Dadurch wird das Konzentrationsprofil nicht mehr nur noch durch den Volumen-Diffusionskoeffizienten bestimmt, und es stellt sich eine von Null verschiedene Konzentration an der Oberfläche ein.

Für die Frage, welche Parameter für ein Bonden in gesättigtem Wasserdampf bzw. für eine Nachbehandlung notwendig sind, ist die Löslichkeit der OH-Gruppen entscheidend. R.H. Doremus, Glass Science, 2nd Ed., Wiley, New York 1994, Seiten 198-199) gibt die Löslichkeit in Quarzglas für den Bereich 700 - 1200°C mit 3 x 10⁻³ SiOH-Gruppen pro SiO2-Gruppe bei 700 mm Hg Dampfdruck an. Dort sowie in dem Artikel "Water in Silica Glass", A. J. Moulson und J. P. Roberts, Trans. Faraday Soc., 1961, 57, 1208-1216, ist auch angegeben, dass die Löslichkeit mit dem Quadrat des Dampfdrucks steigt. Umgerechnet mit Massenzahlen (OH 17, SiO2 60) ergibt sich eine Löslichkeit von 850 ppm OH, was dem typischen OH-Gehalt von direkt abgeschiedenen Quarzgläsern bzw. titandotierten Quarzgläsern entspricht. Bei der Herstellung dieser Gläser wächst neues Glas schneller auf als OH-Gruppen ausdiffundieren können, daher ist es nicht erforderlich, die Ausdiffusion von OH-Gruppen zu berücksichtigen.

Beim Heißbonden wird jedoch kein neues Glas abgeschieden, d.h. die Ausdiffusion muss berücksichtigt werden. Für direkt abgeschiedenes Glas ist ein Wiederauffüllen oder ein Unterbinden der Ausdiffusion von OH-Gruppen bei Partialdrücken des Wasserdampfs nahe 100% möglich, für ein Soot-Glas mit OH-Gehalt um 200 ppm bei Partialdrücken des Wasserdampfs um 25%. Apparativ kann der passende Dampfdruck durch eine Verdampferschale oder eine Wassereinspritzung und über eine Regelung von Frischgasspülung und das Verhältnis von Zuluft- und Abluftdruck erfolgen. Bei Partialdrücken um 100% bietet sich ein Verzicht oder eine Reduzierung der Spülung und die Verwendung eines Überdruckventils an. Auch das eigentliche Bonden kann unter feuchter Atmosphäre stattfinden.

Bei der Durchführung des Heißbonding-Prozesses kann in beiden Fällen, d.h. sowohl bei einem direkt abgeschiedenen Quarzglas als auch bei einem durch einen Soot-Prozess abgeschiedenen Quarzglas ggf. auf ein Abtragen von Material von der Kanalwand verzichtet werden, weil nur ein geringer und tolerierbarer Abfall des OH-Gehalts auftritt.

Bei einer weiteren Ausführungsform ist die Kanalwand zumindest teilweise, insbesondere vollständig von einer bevorzugt metallischen Schutzbeschichtung bedeckt, um die Ausdiffusion von OH-Gruppen zu verhindern. Typischerweise unterdrückt jegliche Art von metallischer Schicht bzw. Beschichtung die Ausdiffusion von OH-Gruppen stark. Geeignete Metalle sollten einen Schmelzpunkt aufweisen, der oberhalb der höchsten Prozesstemperatur beim Heißbonden liegt. Insbesondere Chrom lässt sich gut aufbringen und strukturieren und weist einen ausreichend hohen Schmelzpunkt auf.

Bei einer Schutzbeschichtung in Form von einer oder mehreren Metallschichten, die auf die unverbundenen Teilkörper aufgebracht werden sollen, ist darauf zu achten, dass vor dem Fügen, insbesondere beim Ansprengen, noch Waschvorgänge notwendig sind. Die Werkstoffe und/oder die Waschprozesse sollten daher so ausgewählt werden, dass die Schutzbeschichtung bzw. deren Schichten nicht angegriffen werden.

Idealerweise wird/werden ein jeweiliger Kühlkanal über den gesamten Umfang der Kanalwand und optional auch die spätere Spiegelfläche oder gar alle während des Heißbondens der Atmosphäre ausgesetzten Oberflächen der Teilkörper bzw. des Glaskörpers metallisiert. Es sind hinreichend viele Verfahren zur Metallisierung von Nichtleitern bekannt, wobei die Anforderung einer Innenbeschichtung der Kühlkanäle die Auswahl etwas einschränkt. Es bieten sich Verfahren mit Aufsputtern, einer initialen Abscheidung aus der Gasphase oder aus einer Flüssigkeit nach Anätzen an. Sobald eine sogenannte Primerschicht aufgebracht ist, kann eine dickere Schicht auch eines anderen Metalls galvanisch aufgebracht werden. Es ist möglich, dass die Primerschicht vor dem Heißbonden und die dickere Schicht erst nach dem Heißbonden aufgebracht wird.

Grundsätzlich ist es möglich, dass die Schutzschicht nach dem Heißbonden in dem jeweiligen Kühlkanal verbleibt, es ist aber auch möglich, dass die Schutzschicht z.B. aufgrund ihrer Wirkung auf den thermischen Ausdehnungskoeffizienten nach dem Heißbonden wieder durch Ätzen oder durch Elektrolyse abgetragen wird.

Wie weiter oben beschrieben wurde kann die gesamte Kanalwand des Kühlkanals von der Schutzbeschichtung bedeckt sein, es ist aber ebenfalls möglich, dass nur der obere Wandabschnitt und die seitlichen Wandabschnitte des Kühlkanals ganz oder ggf. nur teilweise (s.u.) von der Schutzschicht überdeckt werden. Eine solche Schutzbeschichtung kann auf besonders einfache Weise aufgebracht werden, wenn eine Vertiefung in den ersten Teilkörper eingefräst und der zweite Teilkörper nicht bearbeitet wird, so dass der Querschnitt des Kühlkanals vollständig in dem ersten Teilkörper liegt. In diesem Fall kann der erste Teilkörper an der Oberfläche, welche die spätere Bondingfläche bildet, vollflächig und inklusive der noch offenen Kühlkanäle bzw. Vertiefungen beschichtet werden. Ein Schleif- oder Polierschritt entfernt die Metallschicht an der späteren Bondingfläche, so dass dreiseitig beschichtete offene Kühlkanäle verbleiben. Der zweite Teilkörper kann in diesem Fall unbeschichtet bleiben oder wird nur im Bereich der späteren Kühlkanäle beschichtet.

Wie weiter oben beschrieben wurde, kann die vor dem Bonden aufgebrachte, ggf. maskierte oder anders strukturierte Schicht recht dünn ausgeführt werden und nur als Primer für eine weitere Galvanisierung oder chemische Abscheidung aus der Lösung nach dem Heißbonden dienen. Dabei kommt es zu einem Wachstum der Schicht in der Dicke, aber auch lateral entlang der beschichteten Oberfläche(n). Sofern die Metallisierung im Bereich des nicht mit den Kühlkanälen versehenen Teilkörpers (im vorliegenden Beispiel des zweiten Teilkörpers) nur wenige 10 µm schmaler als die Kanalbreite ist, kann dieses laterale Wachstum ausreichend sein, um die Lücken zu schließen und die Kanalwand vollständig mit der metallischen Schutzbeschichtung zu versehen.

Bei geschliffenen und ggf. geätzten Kühlkanälen ist von einer Oberflächenrauheit Ra von 5 - 10 µm an der Kanalwand auszugehen. Gerade wenn die Metallisierung aufgedampft oder gesputtert wurde, ist davon auszugehen, dass sie die Täler der Rauheitslandschaft nicht vollständig ausfüllt. Auch hier kann ein nachträgliches Galvanisieren oder chemisches Abscheiden dazu führen, dass diese Lücken geschlossen werden.

Das Verfahren mit lückenloser Metallisierung kann selbstverständlich auch verwendet werden, wenn die Kanäle in den zweiten Teilkörper eingearbeitet sind und der erste Teilkörper als Deckel zum Verschließen der Kühlkanäle dient.

Wie weiter oben beschrieben wurde, kann es bei dem Heißbondingproess auch zum Eindiffundieren von Natrium oder anderen Metallen kommen. Diese unerwünschte Eindiffusion kann durch die von Quarzglas für Anwendungen bei einer Wellenlänge von 193 nm bekannten Maßnahmen wie Absäuern der Werkstücke, Verwendung besonders reiner oder halogengereinigter Hilfsmittel, geeigneter Ofenauskleidung und Kühlung metallischer Oberflächen vermindert werden. Darüber hinaus wirkt die weiter oben beschriebene metallische Schutzbeschichtung, insbesondere unter Verwendung von Chrom, oder der weitere oben beschriebene Abtrag nach dem Heißbonden gegen hohe Konzentrationsgradienten von Metallen nahe der Oberfläche.

Es kann vorteilhaft sein, wenn die Metallisierung bzw. die metallische Schutzschicht definierte Unterbrechungen (z.B. Schlitze) hat, da die Metallschicht einen anderen thermischen Ausdehnungskoeffizienten als das Glas aufweist und daher während des Temperns dazu führt, dass in das umgebende Glas Spannungen eingebracht und eingefroren werden, die sich auch bei einem Entfernen der Metallschicht nur zum Teil entspannen. Diese Spannungen sind über die Lebensdauer des Spiegels konstant und ändern sich nur wenig mit der Temperatur, aber wenn sie lokal im Bereich etlicher 10 nm/cm Doppelbrechung verursachen, kann dies doch zu Spannungswirkungen an der Spiegeloberfläche z.B. in Form von selektivem Abtrag führen.

Bei einer Ausführungsform weist die Kanalwand eine Mehrzahl von Eckbereichen auf und ist nur außerhalb der Eckbereiche von der Schutzbeschichtung bedeckt. Der Kühlkanal weist in der Regel einen im Wesentlichen rechteckigen Querschnitt mit einem oberen Kanalabschnitt, einem unteren Kanalabschnitt und zwei seitlichen Kanalabschnitten auf, die jeweils an den Eckbereichen aneinander angrenzen. Grundsätzlich sind aber auch andere Querschnitts-Geometrien möglich, die mehr oder weniger Eckbereiche oder ggf. keine Eckbereiche aufweisen, wie dies z.B. bei einem Kühlkanal mit einem runden Querschnitt der Fall ist.

Es ist möglich, dass die Schutzbeschichtung einen jeweiligen Kanalabschnitt mit Ausnahme der Eckbereiche überdeckt. In diesem Fall kommt es in den Eckbereichen zu lokaler OH-Verarmung. Da diese Eckbereiche jedoch isoliert sind, kann in diesem Fall anders als bei einer ring- bzw. rohrförmigen Verarmung nur eine viel geringere temperaturabhängige Kraft aufgebaut werden, die zu einer Aufwölbung des Glases über den Kühlkanälen führen würde.

Bei einer weiteren Weiterbildung ist die Kanalwand entlang von sich in Längsrichtung des Kühlkanals erstreckenden, bevorzugt schräg zur Längsrichtung verlaufenden Schlitzen nicht von der Schutzbeschichtung bedeckt. Es ist möglich, dass z.B. ein seitlicher Kanalabschnitt bzw. eine Seitenwand des Kühlkanals über schräge Schlitze in der Schutzbeschichtung verfügt. Dies verringert die Kraftwirkung der Schutzbeschichtung in Längsrichtung des Kühlkanals. Die Schlitze können auch z.B. in Form einer Helix oder dergleichen über sämtliche Wandabschnitte des Kühlkanals fortgesetzt werden.

Nach Ansprengen hydrophiler Glasoberflächen verbleiben in der späteren Bondingfläche eine oder mehrere Monolagen Wasser, die beim Bonden das gewünschte Ausbilden kovalenter Bindungen behindern. Üblicherweise können die Wassermoleküle beim Aufheizen entlang der Bondebene bzw. der Bondingfläche ausdiffundieren. Wenn jedoch vor dem Bonden eine geschlossene Metallisierung einschließlich der offenen Seiten der Bondebene geschaffen wurde, so ist diese Ausdiffusion unterdrückt, und es bleibt nur das sehr langsame Eindiffundieren des Wassers in das Substrat. Es kann vorteilhaft sein, die angesprengten, aber noch nicht oder noch nicht spaltfrei metallisierten Teilkörper für einige Stunden bis wenige Wochen bei 100 bis 400°C auszubacken, um das Spaltwasser auszutreiben. Erst danach erfolgt eine Metallisierung der Kanalinnenseiten bzw. eine Verstärkung einer maskierten partiellen Metallisierung einschließlich des Schließens der Aussparungen.

Bei einer weiteren Ausführungsform**,** die nicht unter die beanspruchte Erfindung fällt, weist der erste Teilkörper, bevorzugt das gesamte Substrat, einen maximalen OH-Gehalt von weniger als 10 Gew.-ppm auf. Je geringer der absolute OH-Gehalt ist, desto geringer ist auch der Gradient des OH-Gehalts, der sich nach dem Heißbonden einstellt.

Entsprechend verringert sich auch der Gradient der Nulldurchgangstemperatur in dem Substrat und somit die Deformation der Oberfläche mit der reflektierenden Beschichtung bzw. die Bildfehler, die im Betrieb des optischen Elements bei der Betriebstemperatur erzeugt werden. Um einen derart niedrigen OH-Gehalt zu erreichen, kann der OH-Gehalt des Quarzglases durch eine geeignete thermische Trocknung oder eine chemische Trocknung (z.B. mittels Halogenen) reduziert werden. Eine chemische Trocknung kann nur bei einem Soot-Prozess vor dem Sintern durchgeführt werden, eine thermische Trocknung kann vor oder nach dem Sintern erfolgen, wobei eine thermische Trocknung nach dem Sintern deutlich länger dauert Bei der thermischen Trocknung können die beiden Teilkörper einzeln oder gemeinsam mehrere Tage oder Wochen bei Temperaturen oberhalb von 1400°C, vorzugsweise oberhalb von 1600°C, getempert werden, bevor die beiden Teilkörper durch Heißbonden zusammengefügt werden. Für die Trocknung ist es nicht erforderlich bzw. eher ungünstig, wenn in einen jeweiligen Teilkörper bereits die Vertiefungen eingebracht wurden, die später die Kühlkanäle bilden, da diese sich bei den Temperaturen, bei denen die thermische Trocknung durchgeführt wird, in der Form ändern würden. Durch die weiter oben beschriebene chemische oder thermische Trocknung ist es möglich, Quarzgläser mit einem OH-Gehalt von weniger als 1 Gew.-ppm herzustellen.

Bei einem weiteren Aspekt , der nicht unter die beanspruchte Erfindung fällt , weist die Kanalwand eines jeweiligen Kühlkanals mindestens eine schlitzförmige Vertiefung auf, die bevorzugt mindestens so tief, besonders bevorzugt mindestens doppelt so tief ist wie die Dicke des Verarmungsbereichs. Die schlitzförmige(n) Vertiefung(en) weisen typischerweise eine Breite von weniger als 100 µm auf und werden vor dem Heißbonden in mindestens einen der Teilkörper eingebracht. Die Tiefe der schlitzförmigen Vertiefungen sollte dabei die Dicke des Verarmungsbereichs um einen Faktor 1, 2 bis 5, aber in der Regel nicht mehr als 5, überschreiten, wobei der Verarmungsbereich wie weiter oben beschrieben definiert ist als der Bereich, in dem der OH-Gehalt um mindestens 5 Gew.-ppm kleiner ist als der OH-Gehalt an der Stegmitte des jeweiligen Stegs bzw. an der Oberfläche. Die OH-Verarmung während des Heißbondens zieht sich um die schlitzförmigen Vertiefungen herum, jedoch ist der von dem Verarmungsbereich gebildete Ring (bezogen auf den Querschnitt des Kühlkanals) bzw. das Rohr (bezogen auf den gesamten Kühlkanal) geschwächt, so dass es zu einer verringerten temperaturabhängigen Aufwölbung oder Vertiefung oberhalb der Kühlkanäle kommt. Sofern die schlitzförmigen Vertiefungen strömungstechnisch ungünstig sind ("flow induced vibrations"), können sie nach dem Heißbonden beispielsweise mit einer weichen organischen Masse verschmiert werden, oder es kann vor dem Betrieb des Spiegels ein Inliner (Schlauch) in den jeweiligen Kühlkanal eingebracht werden.

Bei einer Weiterbildung , die nicht unter die beanspruchte Erfindung fällt , weist die Kanalwand eine Mehrzahl von Eckbereichen auf und die mindestens eine schlitzförmige Vertiefung ist an einem der Eckbereiche gebildet. Wie weiter oben beschrieben wurde, weist der Kühlkanal in der Regel einen mehreckigen, insbesondere rechteckigen Querschnitt auf, an dem ein oberer und unterer Kanalwandabschnitt an Eckbereichen an zwei seitliche Kanalwandabschnitte angrenzen. Die schlitzförmigen Vertiefungen sind bevorzugt an den Eckbereichen gebildet, an denen der untere Kanalwandabschnitt an die beiden seitlichen Kanalwandabschnitte angrenzt. Die schlitzförmigen Vertiefungen erstrecken sich hierbei bevorzugt entweder in Dickenrichtung des Substrats oder quer zur Dickenrichtung. Die schlitzförmigen Vertiefungen müssen nicht in den Eckbereichen eingebracht werden, sondern können z.B. mittig in die seitlichen Kanalwänden eingebracht oder gewendelt oder abschnittsweise schräg in die Wandabschnitte der Kanalwand eingebracht werden.

Bei einer weiteren Ausführungsform weist der erste Teilkörper, insbesondere das gesamte Substrat, einen maximalen Wasserstoff-Gehalt von nicht mehr als 1 x 10¹⁵ Molekülen / cm³, bevorzugt von nicht mehr als als 1 x 10¹⁴ Molekülen / cm³ auf.

Die Untersuchungen zu den Diffusionskonstanten von OH-Gruppen in dem Artikel "Brückner II" fanden an teilsynthetischem Glas statt, das einen OH-Gehalt vergleichbar mit Soot-Glas und niedriger als direkt abgeschiedenes Glas hat. Über den H2-Gehalt des dort untersuchten Quarzglases ist nichts bekannt, vermutlich da Raman-Messungen damals nicht verbreitet waren. Aufgrund der dort beschriebenen Herstellung durch Erschmelzen in einer Knallgasflamme ist von einem OH-Gehalt von 1 x 10¹⁵ bis 5 x 10¹⁶ Molekülen/cm³ auszugehen. Titandotiertes Quarzglas aus einem Soot-Prozess ist für sich wasserstofffrei, jedoch muss das Glas für die Verwendung in Spiegeln für Projektionssysteme für die EUV-Lithographie in der Regel homogenisiert werden, was zu einem Eintrag im Bereich von 1 x 10¹⁵ bis 5 x 10¹⁵ Molekülen/cm³ führen dürfte. Direkt abgeschiedenes titandotiertes Quarzglas hat einen H2-Gehalt, der typischerweise bei ca. 1 x 10¹⁷ Molekülen/cm³ liegt. Direkt abgeschiedene Quarzgläser erreichen sogar H2-Gehalte bis knapp unter 1 x 10²⁰ Moleküle/cm³, so dass dies bei einsprechender Prozessführung auch für titandotierte Gläser zu erwarten ist.

In dem Artikel "Brückner II" wird nicht auf die Ursachen für die Asymmetrie zwischen Ausdiffusion und Eindiffusion von OH-Gruppen eingegangen. Ein Teil der Erklärung dürfte die notwendige Aktivierungsenergie für die Aufspaltung von H₂O sein. Es ist jedoch davon auszugehen, dass die in den damaligen Untersuchungen verwendeten Gläser wasserstoffhaltig waren. Die Wasserstoffdiffusion wird von der Löslichkeit und dem Partialdruck bestimmt. In hochreinem Quarzglas tritt bei 1 atm in 100% Wasserstoff bei ca. 400°C eine Sättigung des gelösten Wasserstoffs bei ca. 5 x 10¹⁷ Molekülen/cm³ ein, bei geringeren Temperaturen ist die Löslichkeit weiter erhöht, jedoch sinkt die Diffusionskonstante. Daraus folgt, dass wasserstoffhaltige Quarzgläser bei allen Temperaturen von Raumtemperatur bis zu den Prozesstemperaturen beim Heißbonden Wasserstoff aus dem Volumen über die Oberfläche verlieren, wenn die umgebende Atmosphäre weitgehend frei von Wasserstoff ist.

Damit sich eine OH-Gruppe der Form Si-OH von der Oberfläche oder aus einem oberflächennahen Bereich des Glaskörpers lösen und als Wasserdampf verdunsten kann, muss sie einen Wasserstoff erwerben.

Am einfachsten geschieht dies nach der Gleichung
SiOH + H2 → SiH + H₂O, sofern ein Wasserstoffmolekül zur Verfügung steht.

Fehlt dieses, so muss der Wasserstoff von einer anderen OH-Gruppe kommen:
2 SiOH → H₂O + Si + SiO.

Beide Spezies sind schon im Volumen des Glases energetisch ungünstig (E'- bzw. NBOH-Zentrum). An der Oberfläche müssten sie rekombinieren, was bei Temperaturen unterhalb von 1000°C recht unwahrscheinlich ist, oder sie müssten wieder Wasser einfangen, was die Ausdiffusion praktisch zum Erliegen bringt. Durch die Verwendung von sehr wasserstoffarmem Glas wird also eine Austrittsbarriere für OH-Gruppen geschaffen, ähnlich wie bei der Verwendung einer oxidierenden Atmosphäre.

Bei der hier beschriebenen Ausführungsform wird daher vorgeschlagen, ein wasserstofffreies oder wasserstoffarmes Glas für die Herstellung des Substrats zu verwenden. Da übliche Gläser für EUV-Spiegel prozessbedingt Wasserstoff enthalten, kann dieser gezielt ausdiffundiert werden. Wie Abbildung 36 aus dem Artikel "Brückner II" zeigt, liegt die Diffusionskonstante von Wasserstoff bei Temperaturen um 400°C um ca. 5 Größenordnungen über der von OH. Es ist also möglich, den Wasserstoff auszutempern, ohne die OH-Verteilung signifikant zu beeinflussen. Bei Temperaturen um 800°C liegt der Unterschied immer noch bei ca. 3 Größenordnungen, was auch eine ausreichende Differenzierung erlaubt.

Bei einer Weiterbildung dieser Ausführungsform weist der zweite Teilkörper in einem Abstand von einem unteren Wandabschnitt des Kühlkanals, welcher mindestens einer Stegbreite und bevorzugt nicht mehr als dem Zehnfachen einer Stegbreite eines jeweiligen Steges entspricht und/oder welcher der Dicke des ersten Teilkörpers und nicht mehr als dem Zehnfachen der Dicke des ersten Teilkörpers zwischen einem oberen Wandabschnitt der Kanalwand und der Oberfläche mit der reflektierenden Beschichtung entspricht, einen Wasserstoff-Gehalt auf, der bei nicht mehr als 50% des mittleren Wasserstoff-Gehalts des zweiten Teilkörpers liegt.

Da die Inhomogenitäten des thermischen Ausdehnungskoeffizienten in dem Glas insbesondere zwischen der Oberfläche, auf der die reflektierende Beschichtung aufgebracht ist, und den Kühlkanälen und ggf. bis zur halben Kanalhöhe störend sind, sollte als kritische Dicke für die Ausdiffusion von Wasserstoff die Dicke des Glases über dem Kühlkanal oder die Stegbreite zwischen den Kanälen herangezogen werden. Die Wasserstoff-Konzentration in der Deckelmitte oder in der Stegmitte sollte vorzugsweise 1 x 10¹⁴ Moleküle/cm³ oder weniger betragen.

In Richtung des zweiten Teilkörpers unterhalb des unteren Wandabschnitts ist es in der Regel ausreichend, wenn der Wasserstoffgehalt auf einer Distanz vom 1- bis 10-fachen der Deckeldicke oder der Stegbreite auf 50% seines Maximums im Substratinneren des zweiten Teilkörpers absinkt. In Folge dessen kommt es zwar noch zu einer leichten OH-Verarmung am Boden bzw. am unteren Wandabschnitt des Kühlkanals und den unteren Bereichen der seitlichen Wandabschnitte, was jedoch wie zuvor ausgeführt, nicht mehr stark ins Gewicht fällt.

Der Wasserstoff-Gehalt wird üblicherweise über Raman-Spektroskopie nachgewiesen, wobei räumliche Auflösungen unterhalb 1 mm kaum zu erreichen sind (außer bei Mikro-Ramanspektroskopie) und die Nachweisgrenze üblicherweise in OH-reichen Quarzgläsern bei 1 bis 5 x 10¹⁵ Molekülen / cm³ liegt. Geeignete Wasserstoff-Verteilungen können über Messpunkte in Deckel- bzw. Stegmitte und eine Folge von Messpunkten vom Kanalboden weiter hinein ins Substrat und/oder entsprechende Diffusionsrechnungen nachgewiesen werden.

Ein weiterer Aspekt der Erfindung betrifft eine optische Anordnung, insbesondere ein EUV-Lithographiesystem, umfassend: mindestens ein optisches Element, das wie weiter oben beschrieben ausgebildet ist, sowie eine Kühleinrichtung, die zum Durchströmen der Mehrzahl von Kühlkanälen mit einer Kühlflüssigkeit ausgebildet ist. Bei dem EUV-Lithographiesystem kann es sich um eine EUV-Lithographieanlage zur Belichtung eines Wafers oder um eine andere optische Anordnung handeln, die EUV-Strahlung verwendet, beispielsweise um ein EUV-Inspektionssystem, z.B. zur Inspektion von in der EUV-Lithographie verwendeten Masken, Wafern oder dergleichen. Bei dem reflektierenden optischen Element kann es sich insbesondere um einen Spiegel eines Projektionssystems einer EUV-Lithographieanlage handeln. Die Kühleinrichtung kann beispielsweise ausgebildet sein, eine Kühlflüssigkeit in Form von Kühlwasser oder dergleichen durch den mindestens einen Kühlkanal strömen zu lassen. Die Kühleinrichtung kann zu diesem Zweck ggf. eine Pumpe sowie geeignete Zuführungs- und Abführungsleitungen aufweisen.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

### Zeichnung

Ausführungsbeispiele sind in der schematischen Zeichnung dargestellt und werden in der nachfolgenden Beschreibung erläutert. Es zeigt
- Fig. 1: schematisch im Meridionalschnitt eine Projektionsbelichtungsanlage für die EUV-Projektionslithografie,
- Fig. 2a,b: schematische Darstellungen eines Rohlings aus titandotiertem Quarzglas mit zwei Teilkörpern, die entlang einer Bondingfläche im Bereich einer Mehrzahl von Kühlkanälen durch Heißbonden miteinander verbunden wurden,
- Fig. 3a: eine schematische Darstellung eines optischen Elements, das aus dem Quarzglas-Rohling von Fig. 2a hergestellt wurde, im Belichtungsbetrieb,
- Fig. 3b: eine schematische Darstellung analog zu Fig. 3a, bei dem an der Kanalwand der Kühlkanäle Material abgetragen wurde,
- Fig. 4a-d: schematische Darstellungen einer auf die Kanalwände aufgebrachten metallischen Schutzbeschichtung zur Vermeidung der Ausbildung einer OH-Verarmungszone beim Heißbonden,
- Fig. 5a-c: schematische Darstellungen der Wände eines Kühlkanals, in die zur Verringerung von durch die OH-Verarmungszone bedingten Spannungen schlitzförmige Vertiefungen eingebracht wurden,
- Fig. 6: eine schematische Darstellung der Verteilung des Wasserstoff-Gehalts in einem Rohling aus titandotiertem Quarzglas beim Austempern von Wasserstoff,
- Fig. 7a: eine schematische Darstellung des Temperaturverlaufs eines Temperprozesseses mit einer Haltetemperatur von 1080°C an einem Rohling aus titandotiertem Quarzglas,
- Fig. 7b: eine schematische Darstellung einer Verteilung des OH-Gehalts in dem Rohling aus titandotiertem Quarzglas nach dem Temperprozess von Fig. 7a,
- Fig. 8a,b: schematische Darstellungen analog zu Fig. 7a,b für einen Temperprozess mit einer Haltetemperatur von 650°C,
- Fig. 9a,b: schematische Darstellungen analog zu Fig. 7a,b für einen Temperprozess mit einer Haltetemperatur von 1200°C,
- Fig. 10a,b: schematische Darstellungen des OH-Gehalts in einem Rohling aus direkt abgeschiedenem Quarzglas beim Heißbonden in gesättigtem Wasserdampf bzw. beim nachträglichen Erhöhen des OH-Gehalts, sowie
- Fig. 11a,b: schematische Darstellungen analog zu Fig. 10a,b für einen Rohling aus Quarzglas, das in einem Soot-Prozess hergestellt wurde.

In der folgenden Beschreibung der Zeichnungen werden für gleiche bzw. funktionsgleiche Bauteile identische Bezugszeichen verwendet.

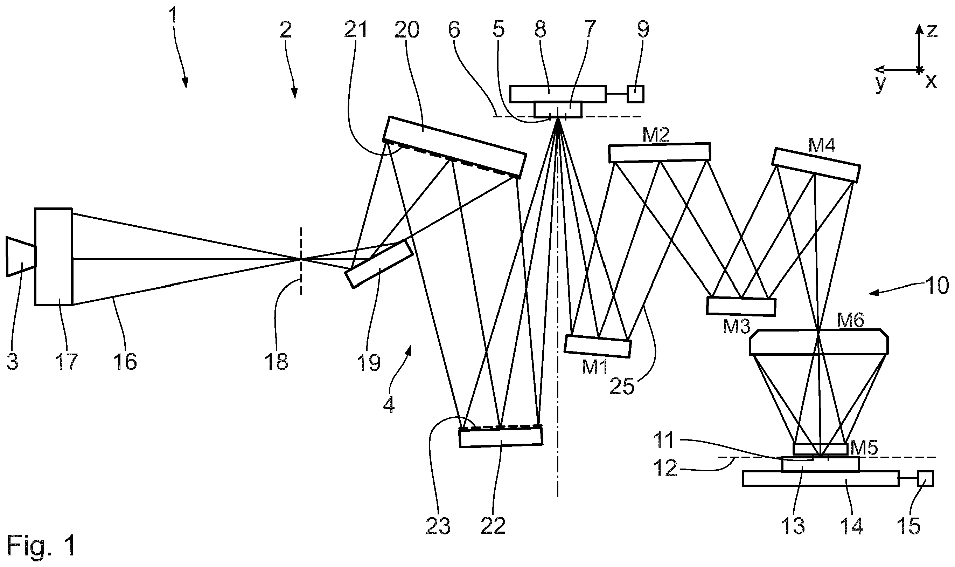

Im Folgenden werden unter Bezugnahme auf Fig. 1 exemplarisch die wesentlichen Bestandteile einer optischen Anordnung für die EUV-Lithographie in Form einer Projektionsbelichtungsanlage 1 für die Mikrolithographie beschrieben. Die Beschreibung des grundsätzlichen Aufbaus der Projektionsbelichtungsanlage 1 sowie von deren Bestandteilen ist hierbei nicht einschränkend zu verstehen.

Eine Ausführung eines Beleuchtungssystem 2 der Projektionsbelichtungsanlage 1 hat neben einer Licht- bzw. Strahlungsquelle 3 eine Beleuchtungsoptik 4 zur Beleuchtung eines Objektfeldes 5 in einer Objektebene 6. Bei einer alternativen Ausführung kann die Lichtquelle 3 auch als ein zum sonstigen Beleuchtungssystem separates Modul bereitgestellt sein. In diesem Fall umfasst das Beleuchtungssystem die Lichtquelle 3 nicht.

Beleuchtet wird ein im Objektfeld 5 angeordnetes Retikel 7. Das Retikel 7 ist von einem Retikelhalter 8 gehalten. Der Retikelhalter 8 ist über einen Retikelverlagerungsantrieb 9 insbesondere in einer Scanrichtung verlagerbar.

In Fig. 1 ist zur Erläuterung ein kartesisches xyz-Koordinatensystem eingezeichnet. Die x-Richtung verläuft senkrecht zur Zeichenebene hinein. Die y-Richtung verläuft horizontal und die z-Richtung verläuft vertikal. Die Scanrichtung verläuft in der Fig. 1 längs der y-Richtung. Die z-Richtung verläuft senkrecht zur Objektebene 6.

Die Projektionsbelichtungsanlage 1 umfasst ein Projektionssystem 10. Das Projektionssystem 10 dient zur Abbildung des Objektfeldes 5 in ein Bildfeld 11 in einer Bildebene 12. Abgebildet wird eine Struktur auf dem Retikel 7 auf eine lichtempfindliche Schicht eines im Bereich des Bildfeldes 11 in der Bildebene 12 angeordneten Wafers 13. Der Wafer 13 wird von einem Waferhalter 14 gehalten. Der Waferhalter 14 ist über einen Waferverlagerungsantrieb 15 insbesondere längs der y-Richtung verlagerbar. Die Verlagerung einerseits des Retikels 7 über den Retikelverlagerungsantrieb 9 und andererseits des Wafers 13 über den Waferverlagerungsantrrieb 15 kann synchronisiert zueinander erfolgen.

Bei der Strahlungsquelle 3 handelt es sich um eine EUV-Strahlungsquelle. Die Strahlungsquelle 3 emittiert insbesondere EUV-Strahlung 16, welche im Folgenden auch als Nutzstrahlung, Beleuchtungsstrahlung oder Beleuchtungslicht bezeichnet wird. Die Nutzstrahlung hat insbesondere eine Wellenlänge im Bereich zwischen 5 nm und 30 nm. Bei der Strahlungsquelle 3 kann es sich um eine Plasmaquelle handeln, zum Beispiel um eine LPP-Quelle (Laser Produced Plasma, mithilfe eines Lasers erzeugtes Plasma) oder um eine DPP-Quelle (Gas Discharged Produced Plasma, mittels Gasentladung erzeugtes Plasma). Es kann sich auch um eine synchrotronbasierte Strahlungsquelle handeln. Bei der Strahlungsquelle 3 kann es sich um einen Freie-Elektronen-Laser (Free-Electron-Laser, FEL) handeln.

Die Beleuchtungsstrahlung 16, die von der Strahlungsquelle 3 ausgeht, wird von einem Kollektorspiegel 17 gebündelt. Bei dem Kollektorspiegel 17 kann es sich um einen Kollektorspiegel mit einer oder mit mehreren ellipsoidalen und/oder hyperboloiden Reflexionsflächen handeln. Die mindestens eine Reflexionsfläche des Kollektorspiegels 17 kann im streifenden Einfall (Grazing Incidence, GI), also mit Einfallswinkeln größer als 45°, oder im normalen Einfall (Normal Incidence, NI), also mit Einfallwinkeln kleiner als 45°, mit der Beleuchtungsstrahlung 16 beaufschlagt werden. Der Kollektorspiegel 17 kann einerseits zur Optimierung seiner Reflektivität für die Nutzstrahlung und andererseits zur Unterdrückung von Falschlicht strukturiert und/oder beschichtet sein.

Nach dem Kollektorspiegel 17 propagiert die Beleuchtungsstrahlung 16 durch einen Zwischenfokus in einer Zwischenfokusebene 18. Die Zwischenfokusebene 18 kann eine Trennung zwischen einem Strahlungsquellenmodul, aufweisend die Strahlungsquelle 3 und den Kollektorspiegel 17, und der Beleuchtungsoptik 4 darstellen.

Die Beleuchtungsoptik 4 umfasst einen Umlenkspiegel 19 und diesem im Strahlengang nachgeordnet einen ersten Facettenspiegel 20. Bei dem Umlenkspiegel 19 kann es sich um einen planen Umlenkspiegel oder alternativ um einen Spiegel mit einer über die reine Umlenkungswirkung hinaus bündelbeeinflussenden Wirkung handeln. Alternativ oder zusätzlich kann der Umlenkspiegel 19 als Spektralfilter ausgeführt sein, der eine Nutzlichtwellenlänge der Beleuchtungsstrahlung 16 von Falschlicht einer hiervon abweichenden Wellenlänge trennt. Der erste Facettenspiegel 20 umfasst eine Vielzahl von einzelnen ersten Facetten 21, welche im Folgenden auch als Feldfacetten bezeichnet werden. Von diesen Facetten 21 sind in der Fig. 1 nur beispielhaft einige dargestellt. Im Strahlengang der Beleuchtungsoptik 4 ist dem ersten Facettenspiegel 20 nachgeordnet ein zweiter Facettenspiegel 22. Der zweite Facettenspiegel 22 umfasst eine Mehrzahl von zweiten Facetten 23.

Die Beleuchtungsoptik 4 bildet somit ein doppelt facettiertes System. Dieses grundlegende Prinzip wird auch als Wabenkondensor (Fly's Eye Integrator) bezeichnet. Mit Hilfe des zweiten Facettenspiegels 22 werden die einzelnen ersten Facetten 21 in das Objektfeld 5 abgebildet. Der zweite Facettenspiegel 22 ist der letzte bündelformende oder auch tatsächlich der letzte Spiegel für die Beleuchtungsstrahlung 16 im Strahlengang vor dem Objektfeld 5.

Das Projektionssystem 10 umfasst eine Mehrzahl von Spiegeln Mi, welche gemäß ihrer Anordnung im Strahlengang der Projektionsbelichtungsanlage 1 durchnummeriert sind.

Bei dem in der Fig. 1 dargestellten Beispiel umfasst das Projektionssystem 10 sechs Spiegel M1 bis M6. Alternativen mit vier, acht, zehn, zwölf oder einer anderen Anzahl an Spiegeln Mi sind ebenso möglich. Der vorletzte Spiegel M5 und der letzte Spiegel M6 haben jeweils eine Durchtrittsöffnung für die Beleuchtungsstrahlung 16. Bei dem Projektionssystem 10 handelt es sich um eine doppelt obskurierte Optik. Die Projektionsoptik 10 hat eine bildseitige numerische Apertur, die größer ist als 0,4 oder 0,5 und die auch größer sein kann als 0,6 und die beispielsweise 0,7 oder 0,75 betragen kann.

Die Spiegel Mi können, genauso wie die Spiegel der Beleuchtungsoptik 4, eine hoch reflektierende Beschichtung für die Beleuchtungsstrahlung 16 aufweisen.

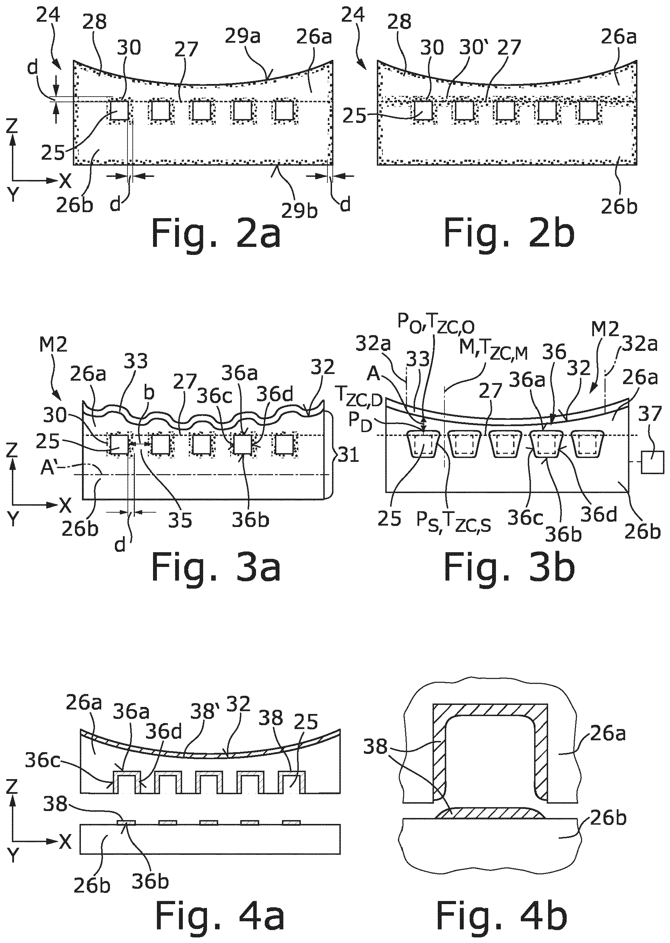

Zur Herstellung eines jeweiligen Spiegels Mi wird ein in **Fig. 2a****,b** gezeigter Glaskörper 24 aus titandotiertem Quarzglas verwendet, der eine Mehrzahl von Kühlkanälen 25 aufweist. Der Glaskörper 24 weist einen ersten, oberen Teilkörper 26a und einen zweiten, unteren Teilkörper 26b auf, die entlang einer im gezeigten Beispiel planen Bondingfläche 27 durch Heißbonden zusammengefügt sind. Die beiden Teilkörper 26a, 26b werden aus einem massiven Glaskörper (ohne Kühlkanäle) gebildet, indem dieser entlang einer im gezeigten Beispiel planen Trennfläche aufgesägt wird.

Für die Herstellung des in Fig. 2a,b gezeigten Glaskörpers 24 wird zunächst der untere Teilkörper 26b mechanisch bearbeitet. Beim mechanischen Bearbeiten wird in das Quarzglas-Material des unteren Teilkörpers 26b eine Mehrzahl von Vertiefungen eingefräst, die im gezeigten Beispiel einen im Wesentlichen quadratischen bzw. rechteckigen Querschnitt aufweisen. Es versteht sich, dass alternativ die Vertiefungen in den ersten Teilkörper 26a eingefräst werden können. Es ist ebenfalls möglich, dass in beide Teilkörper 26a,b Vertiefungen eingefräst werden, die nach dem Zusammenfügen den Querschnitt eines jeweiligen Kühlkanals 25 bilden.

Bei dem in Fig. 2a gezeigten Beispiel werden der erste Teilkörper 26a an der bearbeiteten Oberfläche, welche die spätere Bondingfläche 27 bildet, bei Raumtemperatur auf den zweiten Teilkörper 26b aufgesetzt und an diesem angesprengt. Nachfolgend werden die beiden Teilkörper 26a,b gemeinsam einem Heißbonding-Prozess unterworfen, bei dem die beiden Teilkörper 26a,b sich entlang der Bondingfläche 27 miteinander verbinden. Bei dem in Fig. 2b gezeigten Beispiel werden hingegen der erste Teilkörper 26a und der zweite Teilkörper 26b zunächst getrennt voneinander auf eine hohe Temperatur aufgeheizt und erst nachfolgend miteinander zu dem Glaskörper 24 verbunden.

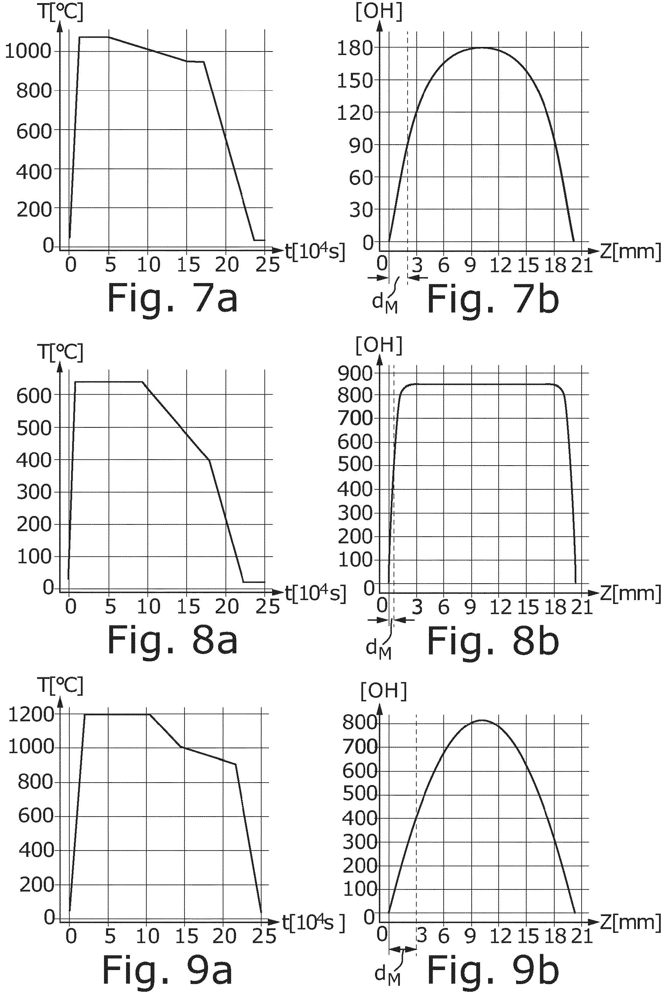

Fig. 7a zeigt ein Beispiel für den Temperaturverlauf eines Temperprozesses an einem Glaskörper aus titandotiertem Quarzglas, wie er in einem Ausführungsbeispiel der US 10,732,519 B2 beschrieben ist und der grundsätzlich auch bei dem weiter oben beschriebenen Heißbonding zum Zusammenfügen der beiden Teilkörper 26a,b eingesetzt werden kann. Bei dem Temperprozess wird der Glaskörper zunächst für 3h auf eine Haltetemperatur von 1080°C aufgeheizt und über eine Haltezeit von 8 h auf der Haltetemperatur gehalten, bevor eine kontrollierte Abkühlung mit einer Abkühlrate von 4 K / h auf eine Temperatur von 950°C erfolgt. Nachdem der Glaskörper über 4 h bei der Temperatur von 950°C gehalten wurde, wird der Glaskörper mit einer höheren Abkühlrate von 50 K / h auf eine Temperatur von 300°C abgekühlt.

**Fig. 7b** zeigt den eindimensionalen (simulierten) Verlauf des OH-Gehalts eines Glaskörpers (ohne Kühlkanäle), der eine Dicke von 2 mm aufweist, entlang der Dickenrichtung (Z-Richtung) des Glaskörpers nach dem Abschluss des Temperprozesses von Fig. 7a. Für die Simulation wurde ein konstanter OH-Gehalt des Glaskörpers in Dickenrichtung von 180 Gew.-ppm vor dem Beginn des Temperprozesses angenommen. Ferner wurde angenommen, dass das Glas ausreichend Wasserstoff enthält, also keine Austrittsbarriere für OH-Gruppen aufgebaut wird. Wie in Fig. 7b zu erkennen ist, liegt der OH-Gehalt (in Gew.-ppm) in der Mitte des Glaskörpers (d.h. bei Z = 1 mm) auch nach dem Temperprozess noch bei 180 Gew.-ppm. Der OH-Gehalt nimmt jedoch zu den Rändern des Glaskörpers (bei Z = 0 cm und bei Z = 2 mm) auf einen Wert von 0 Gew.-ppm ab. Die Verringerung des OH-Gehalts an den Rändern des Glaskörpers ist auf die Ausdiffusion von OH-Gruppen aus dem Quarzglas zurückzuführen.

Für die Simulation wurde davon ausgegangen, dass der Temperprozess in einem Ofen stattfindet, in dem die Umgebung des Glaskörpers einen Wasserdampf-Dampfdruck aufweist, der gegen Null geht, da der Ofen mit Vakuum, Luft oder Inertgas mit ausreichender Umwälzung betrieben wird. Für die Simulation wurden die Diffusionskoeffizienten in Abhängigkeit von der Temperatur verwendet, die in dem weiter oben zitierten Artikel "Brückner I" bzw. in dem weiter oben zitierten Artikel "Brückner II" angegeben sind, vgl. insbesondere Fig. 36 in dem letztgenannten Artikel. Bei den in Fig. 36 des Artikels "Brückner II" mit Typ II bezeichneten Quarzgläsern handelt es sich um Quarzgläser, die aus pulverförmigem Siliziumdioxid unter einer Knallgasflamme eingeschmolzen wurden. Der OH-Gehalt derartiger Quarzgläser ist vergleichbar mit demjenigen eines in einem Soot-Prozess hergestellten Quarzglases und etwas niedriger als der OH-Gehalt von direkt abgeschiedenem Quarzglas, weshalb die in dem Artikel "Brückner II" beschriebenen Werte für die Simulation eingesetzt werden können. Die Ausdiffusion von OH-Gruppen aus Ti-dotiertem Quarzglas erfolgt näherungsweise mit den gleichen temperaturabhängigen Diffusionskonstanten als bei undotiertem Quarzglas, so dass die Diffusionskonstanten von undotiertem Quarzglas auch für titandotiertes Quarzglas angewendet werden können.

Der Abstand vom Rand des Glaskörpers, an dem der OH-Gehalt auf 50% des maximalen Wertes abnimmt, ist in Fig. 7a mit d_{M} bezeichnet und bildet einen Richtwert für die Dicke einer Verarmungszone bzw. eines Verarmungsbereichs des Quarzglases. Bei dem in Fig. 7b gezeigten Beispiel liegt der maximale Wert des OH-Gehalts bei 180 Gew.-ppm und der Wert für die Dicke d_{M} liegt bei ca. 220 µm.

Die Dicke d_{M} der Verarmungszone hängt neben dem maximalen OH-Gehalt des Quarzglases auch vom Temperprozess, insbesondere vom Wert der Haltetemperatur und der Haltezeit ab. Bei einer höheren Haltetemperatur nimmt die Dicke d_{M} der Verarmungszone zu, wie nachfolgend anhand von **Fig. 8a****,b** und **Fig. 9a,b** beschrieben wird.

Fig. 8a zeigt den Temperaturverlauf bei einem Temperprozess, bei dem die Haltetemperatur bei 650°C liegt und die Haltezeit 24 h beträgt. Fig. 8b zeigt den simulierten Verlauf des OH-Gehalts, der von einem maximalen OH-Gehalt von 850 Gew.-ppm in der Mitte des Glaskörpers auf 0 Gew.-ppm am Rand des Glaskörpers abfällt. Wieder wurde angenommen, dass die Voraussetzungen für eine Austrittsbarriere für OH-Gruppen nicht vorliegen. Der OH-Gehalt in der Mitte des Glaskörpers entspricht dem für die Simulation festgelegten, über die Dicke des Glaskörpers konstanten Anfangswert. Die Dicke d_{M} der Verarmungszone liegt in diesem Beispiel bei nur 48 µm.

Fig. 9a zeigt den Temperaturverlauf bei einem Temperprozess, bei dem die Haltetemperatur bei 1200°C liegt und die Haltezeit 24 h beträgt. Auch in diesem Fall wurde angenommen, dass die Voraussetzungen für eine Austrittsbarriere für OH-Gruppen nicht vorliegen. Fig. 9b zeigt den simulierten Verlauf des OH-Gehalts, der von einem maximalen OH-Gehalt von ca. 800 Gew.-ppm in der Mitte des Glaskörpers auf 0 Gew.-ppm am Rand des Glaskörpers abfällt. Die Dicke d_{M} der Verarmungszone liegt in diesem Beispiel bei 290 µm. Auch bei dem in Fig. 9b dargestellten Verlauf des OH-Gehalts wurde wie bei dem in Fig. 8a,b beschriebenen Beispiel für die Simulation ein über die Dicke des Glaskörpers konstanter Wert des OH-Gehalts von 850 Gew.-ppm angenommen. Nach der Durchführung des in Fig. 9a gezeigten Temperprozesses fand somit auch in der Mitte des Glaskörpers eine OH-Verarmung statt.

Auch bei dem weiter oben beschriebenen Heißbonding-Prozess, bei dem die beiden Teilkörper 26a,b entlang der Bondingfläche 27 miteinander verbunden werden, findet eine OH-Verarmung des Quarzglases statt. In Fig. 2a ist beispielhaft ein Verarmungsbereich 28 an der Außenseite bzw. am äußeren Rand des Glaskörpers 24 dargestellt, der insbesondere entlang einer Oberseite 29a des Glaskörpers und an einer Unterseite 29b des Glaskörpers 24 verläuft. Wie in Fig. 2a ebenfalls zu erkennen ist, existiert auch ein Verarmungsbereich 30 in dem Material des Glaskörpers 24, welches an die Kühlkanäle 25 angrenzt. Bei dem in Fig. 2b gezeigten Glaskörper 24 existiert ein weiterer Verarmungsbereich 30', der sich entlang der Bondingfläche 27 zwischen den Kühlkanälen 25 erstreckt, da die beiden Teilkörper 26a,b getrennt voneinander erwärmt wurden. Die Verarmungsbereiche 28, 30, 30' an dem Glaskörper 24 sind in Fig. 2a,b übertrieben breit bzw. dick dargestellt.

**Fig. 3a** zeigt einen Spiegel M2 mit einem Substrat 31, das aus dem in Fig. 2a gezeigten Glaskörper 24 hergestellt wurde. Bei der Herstellung des Substrats 31 wurde der Glaskörper 24 schleifend bearbeitet, um den Verarmungsbereich 28 an der Oberseite 29a und an der Unterseite 29b des Glaskörpers 24 abzutragen. Zusätzlich wurde der Glaskörper 24 bei der Herstellung des Substrats 31 randseitig beschnitten. Beim Schleifen und einem anschließenden Polierschritt wird an der Oberseite 29a des Substrats 31 eine Oberfläche 32 gebildet, auf die nach dem Schleifen und einem anschließenden Polierschritt eine reflektierende Beschichtung 33 aufgebracht wird. Im gezeigten Beispiel, bei dem es sich bei dem Spiegel M2 um einen EUV-Spiegel handelt, ist die reflektierende Beschichtung 33 zur Reflexion von EUV-Strahlung bei einer Betriebswellenlänge im EUV-Wellenlängenbereich zwischen ca. 5 nm und ca. 30 nm ausgebildet und weist zu diesem Zweck eine Mehrzahl von alternierenden Schichten aus einem hoch brechenden und einem niedrig brechenden Material auf. Im vorliegenden Beispiel bei einer Betriebswellenlänge von 13,5 nm handelt es sich bei den Materialien der alternierenden Schichten der reflektierenden Beschichtung 33 um Si und um Mo. Die EUV-Strahlung trifft nur in einem Teilbereich auf die reflektierende Beschichtung 33 auf, der auch als optisch genutzter Bereich 32a bezeichnet wird und dessen äußerer Rand in Fig.3b mit strichpunktierten Linien angedeutet ist. Die Fläche des optisch genutzten Bereichs 32a kann ggf. deutlich kleiner sein als die Fläche, die von der reflektierenden Beschichtung 33 überdeckt wird. Der optisch genutzte Bereich 32a macht das Abbildungslicht, welches das Projektionssystem 10 durchläuft, nach Reflexion an dem Spiegel M2 für eine weitere Verwendung nutzbar.

Bei dem in Fig. 3a gezeigten Beispiel verbleiben die Verarmungsbereiche 30 an den jeweiligen Kühlkanälen 25 in dem Substrat 31. Der OH-Gradient in den Verarmungsbereichen 30 um einen jeweiligen Kühlkanal 25 herum führt zu einer Veränderung der Nulldurchgangstemperatur des thermischen Ausdehnungskoeffizienten des titandotierten Quarzglases. Der Gradient der Nulldurchgangstemperatur führt bei einer gegebenen Temperatur entweder zu umlaufenden Druckspannungen oder zu umlaufenden Zugspannungen in dem Verarmungsbereich 30, der an die Kühlkanäle 25 angrenzt.

Bei dem in Fig. 3a gezeigten Beispiel wurde davon ausgegangen, dass es sich um Druckspannungen handelt, die einerseits eine nicht weiter störende (nicht bildlich dargestellte) Ausdehnung des Quarzglas-Materials in den jeweiligen Kühlkanal 25 hinein und andererseits eine Aufwölbung der Oberfläche 32, auf welche die reflektierende Beschichtung 33 aufgebracht ist, oberhalb der jeweiligen Kühlkanäle 25 bewirkt, die in Fig. 3a übertrieben groß dargestellt ist. Bei der Herstellung des Spiegels M2 wird die Oberfläche 32 zwar poliert, die Glättung bzw. Politur erfolgt aber bei Raumtemperatur und nicht bei der Betriebstemperatur des Spiegels. Daher ist kein vollständiger Abtrag der in Fig. 3a gezeigten Aufwölbungen möglich, so dass diese zu Bildfehlern beim Betrieb des Spiegels M2 bei einer von der Raumtemperatur verschiedenen Betriebstemperatur führen. Die Auswirkungen auf die Bildfehler des Spiegels M2 sind dabei umso größer, je größer die Differenz zwischen der Raumtemperatur und der Betriebstemperatur ist.

Um die in Fig. 3a gezeigten Aufwölbungen bzw. allgemein Deformationen an der Oberfläche 32 des Spiegels M2 zu vermeiden, die auf die OH-Verarmung des Glasmaterials des Substrats 31 beim Heißbonding zurückzuführen sind, ist es günstig, wenn das Substrat 31 im an die Kühlkanäle 25 angrenzenden Volumenbereich einen möglichst kleinen Gradienten des OH-Gehalts bzw. der Nulldurchgangstemperatur sowohl in lateraler Richtung (X-Richtung) als auch in Dickenrichtung (Z-Richtung) aufweist.

Wie in Fig. 3a,b zu erkennen ist, sind jeweils zwei benachbarte Kühlkanäle 25 durch einen Steg 35 voneinander getrennt. Ein jeweiliger Kühlkanal 25 weist einen im gezeigten Beispiel rechteckigen Querschnitt mit einer Kanalwand 36 auf, die vier Wandabschnitte 36a-d aufweist: Einen oberen Wandabschnitt 36a, welcher die Decke des Kühlkanals 25 bildet und benachbart zu der Oberfläche 32 angeordnet ist, an der die reflektierende Beschichtung 33 aufgebracht ist, einen unteren Wandabschnitt 36b, welcher den Boden des Kühlkanals 25 bildet und welcher der Oberfläche 32 mit der reflektierenden Beschichtung 33 abgewandt ist, sowie zwei seitliche Wandabschnitten 36c,d, welche an den oberen Wandabschnitt 36a und an den unteren Wandabschnitt 36b angrenzen.

In Fig. 3b sind eine Position P_{S} in der Mitte (in Z-Richtung) des rechten Wandabschnitts 36d und eine Position P_{D} in der Mitte (in X-Richtung) des oberen Wandabschnitts 36a dargestellt. Bei dem in Fig. 3b gezeigten Beispiel wurde entlang der in Fig. 3a gezeigten Kanalwand 36 über die gesamte Dicke d des Verarmungsbereichs 30 Material abgetragen. An der Mitten-Position P_{S} des seitlichen Wandabschnitts 36d eines jeweiligen Kühlkanals 25, der an den benachbarten Steg 35 angrenzt, weicht die Nulldurchgangstemperatur T_{ZC,S} des Substrats 31 aufgrund des Materialabtrags um weniger als 1,0 K von einer Nulldurchgangstemperatur T_{ZC,M} an einer Stegmitte M des Stegs 35 ab. Der Vergleich zwischen den beiden Nulldurchgangstemperaturen T_{ZC,S}, T_{ZC,M} erfolgt hierbei auf Höhe der Mitten-Position P_{S} des seitlichen Wandabschnitts 36d. Bei dem in Fig. 3b gezeigten Beispiel, bei dem der gesamte Verarmungsbereich 30 abgetragen wurde, ist die obige Bedingung nicht nur an der Position P_{S} in der Mitte des seitlichen Wandabschnitts 36d, sondern entlang des gesamten seitlichen Wandabschnitts 36d erfüllt.

Für den Fall, dass anders als in Fig. 3b dargestellt nicht der gesamte Verarmungsbereich 30 abgetragen wird, kann die Nulldurchgangstemperatur T_{ZC,S} an dem seitlichen Wandabschnitt 36d ggf. auch eine größere Differenz zur Nulldurchgangstemperatur T_{ZC,M} in der Mitte M des Steges 35 aufweisen, die bei weniger als 3,0 K oder bei weniger als 2,0 K liegt. Das Vorzeichen der Differenz T_{ZC,M} - T_{ZC,S} hängt vom Temperprogramm ab, in der Regel führt ein kleinerer OH-Gehalt jedoch zu einer Verringerung der Nulldurchgangstemperatur.

Zur Erfüllung der obigen Bedingung an die Nulldurchgangstemperaturen T_{ZC,S}, T_{ZC,M} ist es in der Regel erforderlich, dass der OH-Gehalt des Substrats 31 an der Position P_{S} in der Mitte des seitlichen Wandabschnitts 36d bzw. entlang des gesamten seitlichen Wandabschnitts 36d um nicht mehr als 60 Gew.-ppm, um nicht mehr als 30 Gew.-ppm bzw. um nicht mehr als 20 Gew.-ppm vom OH-Gehalt an einer Stegmitte M des jeweiligen Stegs 35 abweicht, was ebenfalls durch den weiter oben beschriebenen Materialabtrag erreicht werden kann.

Neben dem lateralen Gradienten des OH-Gehalts wirkt sich auch der Gradient des OH-Gehalts in Dickenrichtung Z des Substrats 31 auf die Nulldurchgangstemperatur und somit auf die Deformation der Oberfläche 32 aus, auf welche die reflektierende Beschichtung 33 aufgebracht ist. Bei dem in Fig. 3b gezeigten Beispiel weist das Substrat 31 an der Position P_{D} in der Mitte des oberen Wandabschnitts 36a eine Nulldurchgangstemperatur T_{ZC,D} auf, die weniger als 1,0 K von einer Nulldurchgangstemperatur T_{ZC,D} an einer Position P_{O} an der Oberfläche 32 abweicht, die sich in einem Abstand A von der Position P_{D} in der Mitte des oberen Wandabschnitts 36a befindet. Der Abstand A wird hierbei in Dickenrichtung Z ausgehend von der Position P_{D} in der Mitte des oberen Wandabschnitts 36a gemessen, d.h. die Position P_{O} an der Oberfläche 32 befindet sich in Z-Richtung unmittelbar oberhalb der Position P_{D}. Aufgrund des vollständigen Abtrags des Verarmungsbereichs 30 ist die obige Bedingung an die Nulldurchgangstemperaturen T_{ZC,D}, Z_{ZC,O} an allen Positionen entlang des oberen Wandabschnitts 36a erfüllt.

Wie in Zusammenhang mit dem lateralen Gradienten der Nulldurchgangstemperatur beschrieben wurde, kann für den Fall, dass nicht der gesamte Verarmungsbereich 30 abgetragen wird, auch die Nulldurchgangstemperatur T_{ZC,D} an dem oberen Wandabschnitt 36a ggf. eine größere Differenz zur Nulldurchgangstemperatur T_{ZC,D} an der Oberfläche 32 oberhalb der Kanalwand 36 aufweisen, die bei weniger als 3,0 K oder bei weniger als 2,0 K liegt.

Um die obige Bedingung an die Nulldurchgangstemperaturen T_{ZC,D}, T_{ZC,D} zu erfüllen, ist es in der Regel erforderlich, dass der OH-Gehalt des Substrats 31 an der Position P_{D} in der Mitte des oberen Wandabschnitts 36a bzw. entlang des gesamten oberen Wandabschnitts 36a um nicht mehr als 60 Gew.-ppm, um nicht mehr als 30 Gew.-ppm bzw. um nicht mehr als 20 Gew.-ppm vom OH-Gehalt an der Position P_{O} an der Oberfläche 32 abweicht, die sich in dem Abstand A in Dickenrichtung Z oberhalb der Position P_{D} in der Mitte des oberen Wandabschnitts 36a des Kühlkanals 25 befindet, was durch den Materialabtrag erreicht werden kann.

Eine dem oberen Wandabschnitt 36a der Kanalwand 36 entsprechende Bedingung an die Nulldurchgangstemperatur bzw. an den OH-Gehalt muss an dem unteren Wandabschnitt 36b der Kanalwand 36 in der Regel nicht eingehalten werden, da eine Aufwölbung des unteren Wandabschnitts 36b in das Innere des jeweiligen Kühlkanals 25 hinein erfolgt und daher nicht unmittelbar zu einer Deformation an der Oberfläche 32 führt, auf welche die reflektierende Beschichtung 33 aufgebracht ist. Zudem ist die Temperaturerhöhung durch den Wärmeeintrag bei der Bestrahlung des Spiegels M2 an dessen Oberfläche 32 an dem unteren Wandabschnitt 36b der Kanalwand 36 eines jeweiligen Kühlkanals 25 vergleichsweise gering.

Beim Betrieb des Spiegels M2 bzw. beim Aufheizen des Spiegels M2 auf seine Betriebstemperatur wird bei der Einhaltung der oben beschriebenen Bedingungen die Oberfläche 32 des Spiegels M2 nicht bzw. nur geringfügig deformiert. Zur Kühlung des Spiegels M2 während des Betriebs können die Kühlkanäle 25 mit Hilfe einer in Fig. 3b angedeuteten Kühleinrichtung 37 mit einem Kühlfluid, z.B. mit Kühlwasser, durchströmt werden. Die Kühleinrichtung 37 kann zu diesem Zweck z.B. eine Pumpe oder dergleichen aufweisen.

Aufgrund des Abtragens des Materials von der in Fig. 3a gezeigten Kanalwand 36 weist das Substrat 31 entlang der gesamten in Fig. 3b gezeigten Kanalwand 36 einen von Null verschiedenen OH-Gehalt auf. Abhängig von der Tiefe, über die Material abgetragen wird, kann der OH-Gehalt an der Kanalwand 36 größer als 60 Gew.-ppm, größer als 120 Gew.-ppm oder ggf. deutlich größer sein. Die Tiefe, über die Material von der Kanalwand 36 abgetragen werden sollte, hängt u.a. vom maximalen bzw. mittleren OH-Gehalt in dem Substrat 31 ab. Handelt es sich um ein in einer Direktabscheidung hergestelltes Glas, weist dieses üblicherweise einen vergleichsweise großen maximalen OH-Gehalt von ca. 850 Gew.-ppm auf, vgl. beispielsweise Fig. 8b und Fig. 9b. Da der OH-Gehalt bei der Ausdiffusion bis auf 0 Gew.-ppm abfällt, ist in diesem Fall in der Regel ein größerer Abtrag erforderlich als bei einem Glas, das in einem Soot-Prozess hergestellt wurde und bei dem der maximale bzw. mittlere OH-Gehalt in der Größenordnung von ca. 200 Gew.-ppm liegt.

Da abhängig von der Art des Material abtragenden Verfahrens der Abtrag vergleichsweise lange dauert und entsprechend hohe Kosten verursacht und das Problem der mangelnden Formtreue des Abtrags besteht, ist es ggf. schwierig, den gesamten Verarmungsbereich 30 abzutragen. Der Verarmungsbereich 30, der im vorliegenden Fall definiert ist als derjenige an die Kanalwand 36 angrenzende Bereich, in dem der OH-Gehalt des Substrats 31 um mindestens 5 Gew.-ppm kleiner ist als der OH-Gehalt an der Stegmitte M des angrenzenden Stegs 35 und/oder kleiner ist als der OH-Gehalt an der Oberfläche 32 sollte daher eine möglichst geringe Dicke d aufweisen. Insbesondere sollte die Dicke d - ggf. nach dem weiter oben beschriebenen Abtrag von Material - bei weniger als 50 µm, bei weniger als 30 µm oder bei weniger als 1 µm liegen.

Für den Abtrag von Material von der Kanalwand 36 bestehen verschiedene Möglichkeiten. Beispielsweise kann die Kanalwand 36 nach dem Heißbonden mit einer abrasiven Emulsion oder einer Ätzlösung behandelt werden. Für den Fall, dass ein Verarmungsbereich 30 mit einer Dicke von mehr als 1 mm abgetragen werden soll, ist es günstig, für den Abtrag heiße Phosphorsäure zu verwenden. Die Ätzwirkung kann auch mit Hilfe einer Vorschädigung des Glasmaterials z.B. unter Verwendung eines Kurzpulslasers oder durch eine Ultraschall-Beschallung räumlich gesteuert werden. Hierbei kann ein bevorzugter Abtrag an dem oberen Wandabschnitt 36a und im oberen Bereich der seitlichen Wandabschnitte 36c,d erfolgen, wie dies in Fig. 3b angedeutet ist. Insbesondere in Kombination mit der Vorschädigung können auch Laugen als Ätzmittel verwendet werden. Generell ist es günstig, wenn ein langsames Ätzmittel, z.B. Phosphorsäure oder eine Lauge, eingesetzt wird, da bei geringer Ätzrate mit geringen Strömungsgeschwindigkeiten gearbeitet werden kann, was einen homogenen Ätzabtrag ermöglicht.

Wie nachfolgend anhand von **Fig. 4a****-d** beschrieben wird, kann die Ausdiffusion von OH-Gruppen aus dem Glasmaterial des Substrats 31 bzw. aus den beiden Teilkörpern 26a,b und somit das Auftreten eines OH-Gradienten während des Heißbondens durch das (ggf. temporäre) Aufbringen einer Schutzbeschichtung 38 auf die Kanalwand 36 verhindert werden. Zu diesem Zweck enthält die Schutzbeschichtung 38 mindestens ein Material, das die Ausdiffusion von OH-Gruppen verhindert. Die Schutzbeschichtung 38 weist zu diesem Zweck typischerweise mindestens eine Metallschicht auf, da jegliche Art von Metallschicht die OH-Ausdiffusion stark unterdrückt. Geeignete Metalle sollten einen Schmelzpunkt oberhalb der höchsten Prozesstemperatur beim Heißbonden aufweisen. Im gezeigten Beispiel handelt es sich bei der Schutzbeschichtung 38 um eine Chrom-Beschichtung. Chrom hat neben einem hohen Schmelzpunkt den Vorteil, dass dieses sich gut aufbringen und strukturieren lässt.

Die Metalloberfläche der Schutzbeschichtung 38 der Kühlkanäle 25 kann bei dem Heißbonding-Prozess dadurch geschützt werden, dass dieser in Inertgas oder Vakuum durchgeführt wird. Alternativ kann ein Metall ausgewählt werden, das eine bei den verwendeten Temperaturen ausreichend stabile Oxidschicht aufweist, oder die metallische Schutzbeschichtung 38 kann mit anderen oxidischen oder nichtmetallischen Schutzschichten überzogen werden. Auch kann eine Abfolge von verschiedenen Metallen, Metallen und Halbmetallen oder Metallen und Oxiden verwendet werden, um eine stärkere Barrierenwirkung zu erzielen. Ein üblicher MoSi-Multilayer, wie er zur Verspiegelung von EUV-Optiken verwendet wird, hat eine nahezu unendliche Barrierenwirkung für Wasserstoff. Jedoch eignet sich Molybdän aufgrund seiner geringen Schmelztemperatur nur für relativ kalte Bondingprozesse, oder es müssen weitere Schutzschichten auf den Mo-Si-Multilayer aufgebracht werden.

Idealerweise wird die Kanalwand 36 über den gesamten Kanalumfang und ggf. auch die spätere Spiegelfläche 32 mit der metallischen Schutzbeschichtung 38 überzogen, wie dies in Fig. 4a dargestellt ist. Es können auch alle während des Heißbondens der umgebenden Atmosphäre ausgesetzten Oberflächen des Glaskörpers 24 bzw. der beiden Teilkörper 26a,b mit der Schutzbeschichtung 38 versehen bzw. metallisiert werden. Für die Metallisierung bieten sich Verfahren mit Aufsputtern, einer initialen Abscheidung aus der Gasphase oder aus einer Flüssigkeit nach dem Anätzen an. Sobald eine sogenannte Primerschicht aufgebracht ist, kann eine dickere Schicht auch eines anderen Metalls galvanisch aufgebracht werden.

Bei dem in Fig. 4a gezeigten Beispiel sind die Kühlkanäle 25 bzw. die entsprechenden Vertiefungen in den ersten Teilkörper 26a eingearbeitet. Der erste Teilkörper 26a wird in diesem Fall mindestens an seiner die spätere Bondfläche 27 bildenden Oberfläche vollflächig und inklusive der noch offenen Kühlkanäle 25 mit der Schutzbeschichtung 38 beschichtet. Ein Schleif- oder Polierschritt entfernt die Metallschicht an der späteren Bondingfläche 27, so dass in dem ersten Teilkörper 26a dreiseitig, d.h. in dem oberen Wandabschnitt 36a und an den beiden seitlichen Wandabschnitten 36c,d beschichtete offene Kühlkanäle 25 verbleiben. Bei dem in Fig. 4a gezeigten Beispiel ist auch die spätere Spiegeloberfläche 32 mit einer metallischen Schutzbeschichtung 38' beschichtet, dies ist aber nicht zwingend erforderlich.

Der zweite Teilkörper 26b kann grundsätzlich unbeschichtet bleiben oder wird nur im Bereich der unteren Wandabschnitte 36b der späteren Kühlkanäle 25 beschichtet, wie dies in Fig. 4a dargestellt ist. Die Beschichtung des zweiten Teilkörpers 26b an den unteren Wandabschnitten 36b kann durch vollflächiges Metallisieren und maskiertes Ätzen der späteren Bondingfläche 27 erfolgen oder durch Aufbringen einer Maske und selektive Beschichtung. Die metallisierten Bereiche müssen dabei in der Regel etwas schmaler als die Kühlkanäle 25 ausgeführt werden, da insbesondere bei einem Heißbonding-Prozess mit Ansprengen keine perfekte Positionierung des ersten Teilkörpers 26a auf dem zweiten Teilkörper 26b möglich ist. Somit verbleibt der untere Wandabschnitt 26d eines jeweiligen Kühlkanals 25 entweder vollständig oder entlang seiner seitlichen Kanten unbeschichtet. Die daraus resultierenden Verarmungszonen erstrecken sich in das Substrat 31 hinein und haben somit eine deutlich geringere Auswirkung auf die Deformation der Spiegeloberfläche 32 als Funktion der Temperatur als Verarmungszonen 30 an dem oberen Wandabschnitt 36a der Kühlkanäle 31.

Die vor dem Heißbonden aufgebrachte, ggf. maskierte oder anders strukturierte Schutzbeschichtung 38 kann recht dünn ausgeführt werden und nur als Primer für eine weitere Galvanisierung oder chemische Abscheidung aus der Lösung nach dem Heißbonden dienen. Dabei kommt es zu einem Wachstum der Schutzbeschichtung 38 in der Dicke, aber auch lateral entlang der beschichteten Oberflächen. Sofern die Metallisierung im Bereich des nicht mit Kühlkanälen 25 versehenen, im gezeigten Beispiel zweiten Teilkörpers 26b nur wenige 10 µm schmaler als die Breite des Kühlkanals 25 ist, kann dieses laterale Wachstum ausreichend sein, um die Lücken zu schließen und den Kühlkanal 25 entlang des gesamten Kanalumfangs mit der Schutzbeschichtung 38 zu überdecken. Ein nachträgliches Galvanisieren oder chemisches Abscheiden kann auch dazu beitragen, um Lücken in der Metallisierung zu schließen, die ggf. aufgrund der Rest-Rauigkeit der Kanalwand 36 der Kühlkanäle 25 entstehen.

Zur Unterdrückung der Wasserstoffausdiffusion ist je nach verwendetem Metall, Rissfreiheit, Schichtstruktur (kolumnar, amorph, körnig) und Prozesstemperatur und -dauer eine Schutzbeschichtung 38 mit wenigen Atomlagen ausreichend. Die Schutzbeschichtung 38 sollte auch nicht unnötig dick werden, da es dann aufgrund des zum Glas unterschiedlichen thermischen Ausdehnungskoeffizienten der Schutzbeschichtung 38 zu einem unnötig hohen Eintrag von Spannungen in das Glas während des Temperns kommt. Gerade bei rauen Glasoberflächen oder Schlitzen aus dem Maskierungsprozess kann jedoch eine finale Schichtdicke der Schutzbeschichtung 38 im µm-Bereich notwendig werden, um Dichtheit zu erzielen. Dünnere Schichten können jedoch durch heiße Ionenstrahlprozesse oder Glaskugelstrahlen gezielt in Täler oder Ecken / Spalte gedrückt werden, um insgesamt mit einer dünneren Schutzbeschichtung 38 arbeiten zu können.

Bei Bondingtemperaturen von > 1200°C ist es auch möglich, den metallisierten Streifen der Schutzbeschichtung 38 auf dem zweiten Teilkörper 26b etwas breiter als den beschichteten Kühlkanal 25 im ersten Teilkörper 26a auszuführen, insbesondere wenn die Flanken der Metallisierung relativ weich verlaufen, wie dies in Fig. 4b dargestellt ist. Die Flanken der Metallisierung bzw. der Schutzschicht 38 bewirken in diesem Fall einen Restspalt zwischen dem ersten Teilkörper 26a und dem zweiten Teilkörper 26b. Bei den hohen Temperaturen und gegebenenfalls unterstützt durch einen zusätzlichen Anpressdruck schmiegt sich der erste Teilkörper 26a in diesem Fall zwischen den Metallisierungen an den zweiten Teilkörper 26b an. Nach dem Heißbonden sollten verbleibende Metallreste aus den Kanten der Kühlkanäle 25 geätzt werden, da sie einen stark unterschiedlichen thermischen Ausdehnungskoeffizienten zum Glasmaterial des Substrats 31 aufweisen, das sie dreiseitig einschließt. Die verbleibende Kerbe im Glas sollte durch geeignete Bearbeitung mit einem rotierenden Werkzeug an einer biegsamen Welle, Spülung mit einer schleifenden Emulsion oder Ätzen verrundet werden. Zur Verbesserung des Strömungsverhaltens kann sie zudem mit einer dauerelastischen Substanz aufgefüllt werden oder ein organischer Inliner verwendet werden. Das Verfahren mit lückenloser Metallisierung kann selbstverständlich auch verwendet werden, wenn die Kühlkanäle 25 nicht in den ersten Teilkörper 26a, sondern in den zweiten Teilkörper 26b eingearbeitet sind.

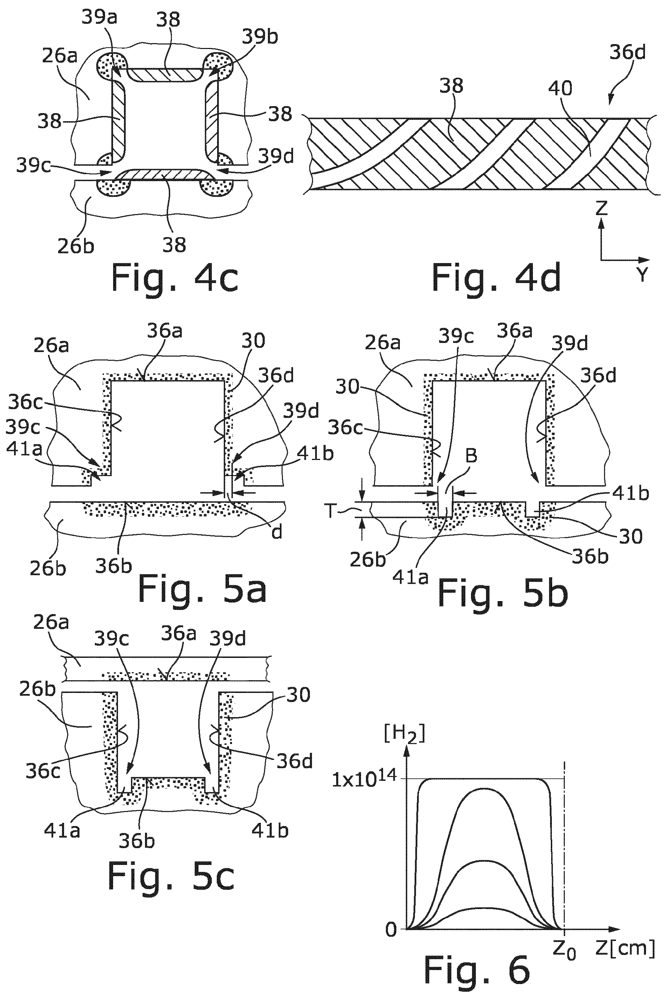

Es kann vorteilhaft sein, wenn die metallische Schutzbeschichtung 38 definierte Unterbrechungen (Schlitze) hat, da das metallische Material der Schutzbeschichtung 38 einen anderen thermischen Ausdehnungskoeffizienten als das Glas aufweist und daher während des Temperns dazu führt, dass in das umgebende Glas Spannungen eingebracht und eingefroren werden, die sich auch bei einem Entfernen der metallischen Schutzschicht 38 nur zum Teil entspannen. Fig. 4c zeigt ein Beispiel, bei dem die Kanalwand 36 in vier Eckbereichen 39a-d, die jeweils zwischen zwei benachbarten Wandabschnitten 36a-d der Kanalwand 36 angeordnet sind, nicht von der Schutzbeschichtung 38 bedeckt ist, d.h. die Kanalwand 36 ist nur außerhalb der Eckbereiche 39a-d von der Schutzbeschichtung 38 bedeckt und die Eckbereiche 39a-d sind ausgespart. Wie in Fig. 4c angedeutet ist, kommt es daher in den Eckbereichen 39a-d zu einer lokalen OH-Verarmung. Da die Eckbereiche 39a-d jedoch isoliert sind, kann anders als bei dem in Fig. 3a gezeigten ring- bzw. rohrförmigen Verarmungsbereich nur eine viel geringere temperaturabhängige Kraft aufgebaut werden, die zu einer Aufwölbung des Glases über den Kühlkanälen 25 führen würde.

Fig. 4d zeigt ein weiteres Beispiel einer Schutzbeschichtung 38, die entlang eines seitlichen Wandabschnitts 36d des Kühlkanals 25 verläuft, in einer Draufsicht in Längsrichtung Y des Kühlkanals 25. Wie in Fig. 4d zu erkennen ist, weist die Schutzbeschichtung 38 schräge Schlitze 40 auf, an denen der seitliche Wandabschnitt 36d nicht von der Schutzbeschichtung 38 überdeckt ist, um die Kraftwirkung in Längsrichtung Y des Kühlkanals 25 zu verringern. Es versteht sich, dass die Schlitze 40 auch in Form einer Helix oder dergleichen über sämtliche vier Wandabschnitte 36a-d des Kühlkanals 25 fortgesetzt werden können.

Nach Ansprengen hydrophiler Glasoberflächen verbleiben an der Fügefläche eine oder mehrere Monolagen Wasser, die beim Bonden das gewünschte Ausbilden kovalenter Bindungen behindern. Üblicherweise können die Wassermoleküle beim Aufheizen entlang der Bondingfläche 27 ausdiffundieren. Wenn jedoch vor dem Bonden eine geschlossene Metallisierung einschließlich der offenen Seiten der Bondingfläche 27 geschaffen, so ist diese Ausdiffusion unterdrückt, und es bleibt nur das sehr langsame Eindiffundieren von Wasser in den Glaskörper 24. Es kann vorteilhaft sein, die beiden angesprengten, aber noch nicht oder noch nicht spaltfrei metallisierten Teilkörper 26a,b für einige Stunden bis wenige Wochen bei 100°C bis 400°C auszubacken, um das Spaltwasser auszutreiben. Erst danach erfolgt eine Metallisierung der Kanalinnenseiten bzw. eine Verstärkung einer maskierten partiellen Metallisierung einschließlich des Schließens der Aussparungen in der metallischen Schutzbeschichtung 38.

Bei den oben beschriebenen Beispielen wurde davon ausgegangen, dass die Kühlkanäle 25 bzw. deren Querschnitt vollständig in den ersten Teilkörper 26a oder in den zweiten Teilkörper 26b eingebracht werden. Selbstverständlich können die Kühlkanäle 25 auch in beide Teilkörper 26a,b eingebracht werden. Sofern der Querschnitt des Kühlkanals 25 sich in diesem Fall aus einer Fräsung im ersten Teilkörper 26a und einer Fräsung im zweiten Teilkörper 26b zusammensetzt, ist es am einfachsten, eine weitgehend geschlossene metallische Schutzbeschichtung 38 sowohl auf den ersten Teilkörper 26a als auch auf den zweiten Teilkörper 26b aufzubringen und danach erst die zu bondenden Bereiche der Oberflächen der beiden Teilkörper 26a,b zu polieren. In diesem Fall verbleibt eine metallfreie Bondingfläche 27 und bis nahe an die Bondstelle rundum beschichtete Kühlkanäle 25. Der minimale unbeschichtete Bereich an den Kanalseiten angrenzend an die Bondstelle, der durch Kantenabrundung oder das Anbringen von Fasen entsteht, ist hinsichtlich der Wirkung auf den thermischen Ausdehnungskoeffizienten meist unbedenklich, da dieser lokal sehr begrenzt ist. Ferner erlaubt er gerade das Ausdiffundieren von Spaltwasser.

Sofern die Schutzbeschichtung 38 z.B. aufgrund ihrer Wirkung auf den thermischen Ausdehnungskoeffizienten des Glases störend ist, kann sie nach dem Heißbonding-Prozess wieder durch Ätzen oder Elektrolyse abgetragen werden.

Eine weitere Möglichkeit zur Verhinderung der Ausdiffusion von OH-Gruppen aus dem Quarzglas besteht darin, die Kühlkanäle während des Heißbondens mit einem Glaspulver aufzufüllen, das den gleichen oder einen höheren OH-Gehalt als das Glas des Substrats aufweist. Sofern der Füllgrad der Kühlkanäle über 10% liegt, sollte dazu Ti-dotiertes Quarzglas mit näherungsweise der gleichen Konzentration wie im Substrat verwendet werden, oder der Ti-Gehalt sollte so eingestellt werden, dass das Glaspulver eine geringere Ausdehnung als das Substrat hat.

Eine weitere Möglichkeit zur Reduzierung von Bildfehlern an dem optischen Element M2, bei der ggf. auf einen Materialabtrag oder auf das Aufbringen einer Schutzbeschichtung 38 verzichtet werden kann, wird nachfolgend in Zusammenhang mit **Fig. 5a****-c** beschrieben, welche den ersten und den zweiten Teilkörper 26a,b vor dem Zusammenfügen zeigen. Bei dem in Fig. 5a gezeigten Beispiel weist die Kanalwand 36 an dem ersten Teilkörper 26a und bei den in Fig. 5b,c gezeigten Beispielen weist die Kanalwand 36 an dem zweiten Teilkörper 26b zwei schlitzförmige Vertiefungen 41a,b auf. In Fig. 5a-c ebenfalls angedeutet ist der an die Kanalwand 36 angrenzende Verarmungsbereich 30, der sich nach dem Heißbonden der beiden Teilkörper 26a,b ausbildet und dessen Dicke d im gezeigten Beispiel bei ca. 100 µm liegt. Wie in Fig. 5a-c zu erkennen ist, zieht sich der Verarmungsbereich 30, der während des Heißbondens gebildet wird, um die schlitzförmigen Vertiefungen 41a,b herum. Der ringförmige Verarmungsbereich 30 entlang des Querschnitts des jeweiligen Kühlkanals 25 wird durch die schlitzförmigen Vertiefungen 41a,b geschwächt, so dass es zu einer verringerten temperaturbedingten Aufwölbung bzw. Vertiefung der Oberfläche 32 oberhalb der Kühlkanäle 25 kommt, was zu reduzierten Abbildungsfehlern im Betrieb des optischen Elements M2 führt.

Um dies zu erreichen, sollten die schlitzförmigen Vertiefungen 41a,b eine Tiefe T aufweisen, die mindestens der Dicke d des Verarmungsbereichs 30 entspricht. Es ist günstig, wenn die Tiefe T mindestens dem Doppelten der Dicke d des Verarmungsbereichs 30 entspricht, d.h. im gezeigten Beispiel ca. 200 µm, die Tiefe T sollte aber in der Regel nicht größer sein als das Fünffache der Dicke d des Verarmungsbereichs 30. Die Breite B der jeweiligen schlitzförmigen Vertiefung 41a,b sollte in der Größenordnung von ca. 100 µm oder darüber liegen.

Bei allen drei in Fig. 5a-c gezeigten Beispielen sind die schlitzförmigen Vertiefungen 41a,b in den beiden Eckbereichen 39c, 39d zwischen einem jeweiligen seitlichen Wandabschnitt 36c, 36d und dem unteren Wandabschnitt 36b gebildet. Bei dem in Fig. 5a gezeigten Beispiel sind die schlitzförmigen Vertiefungen 41a,b in den oberen Teilkörper 26a eingeschliffen, in dem in diesem Beispiel der Querschnitt des Kühlkanals 25 verläuft. Bei dem in Fig. 5b gezeigten Beispiel sind die beiden schlitzförmigen Vertiefungen 41a,b in die ansonsten plane Oberfläche des zweiten, unteren Teilkörpers 26b eingeschliffen. Bei dem in Fig. 5c gezeigten Beispiel befindet sich der Querschnitt des Kühlkanals 25 in dem zweiten, unteren Teilkörper 26b und die schlitzförmigen Vertiefungen 41a,b verlaufen von dem unteren Wandabschnitt 36b nach unten (in Z-Richtung). Eine seitliche Verbreiterung des Kühlkanals 25 im Bereich der späteren Bondingfläche 27, wie sie in Zusammenhang mit Fig. 5a dargestellt ist, ist bei dem in Fig. 5c gezeigten Beispiel ggf. ebenfalls möglich, auch wenn die Unstetigkeit in diesem Fall nahe an der Oberfläche 32 des optischen Elements M2 angeordnet ist.

Es versteht sich, dass die schlitzförmigen Vertiefungen 41a,b auch an anderer Stelle entlang der Kanalwand 36 angeordnet werden können, beispielsweise in der Mitte der seitlichen Wandabschnitte 36c,d. Auch können die schlitzförmigen Vertiefungen 41a,b ähnlich wie die in Zusammenhang mit Fig. 4a-c beschriebenen Schlitze 40 gewendelt oder abschnittsweise schräg in den jeweiligen Kühlkanal 25 eingebracht werden. Für den Fall, dass die schlitzförmigen Vertiefungen 41a,b bei der Durchströmung der Kühlkanäle 25 mit einem Kühlmedium stören sollten, können diese beispielsweise mit einer welchen organischen Masse verschmiert bzw. geschlossen werden oder es kann ein Inliner bzw. ein Schlauch in den jeweiligen Kühlkanal 25 eingebracht werden.

Eine weitere Möglichkeit, um bei dem weiter oben beschriebenen Heißbonding-Prozess einen möglichst kleinen Gradienten des OH-Gehalts des titandotierten Quarzglases zu erzeugen, besteht darin, dass das Substrat 31 des optischen Elements M2 einen geringen maximalen OH-Gehalt aufweist. Der in Fig. 3a dargestellte Effekt der Deformation der mit der reflektierenden Beschichtung 33 bedeckten Oberfläche 32 kann typischerweise vermieden werden, wenn das Substrat 31, zumindest aber der obere Teilkörper 26a, einen maximalen OH-Gehalt von weniger als 10 Gew.-ppm aufweist.

Um dies zu erreichen, kann der OH-Gehalt des Quarzglases des Grundkörpers 24 durch eine geeignete thermische Trocknung oder eine chemische Trocknung (z.B. mittels Halogenen) bei der Herstellung des Grundkörpers 24 in einem Soot-Prozess vor dem Sintern reduziert werden. Durch eine solche Trocknung ist es möglich, Quarzgläser mit einem OH-Gehalt von weniger als 1 Gew.-ppm herzustellen, wie dies für Anwendungen im IR- oder DUV-Wellenlängenbereich bekannt ist. Auf die gleiche Weise kann auch extrem trockenes titandotiertes Quarzglas hergestellt werden, wie es für das hier beschriebene Substrat 31 des EUV-Spiegels M2 benötigt wird. Da trockene Gläser schwer umzuformen und zu homogenisieren sind, bietet es sich an, das Homogenisieren des Ti-Gehalts bereits am Soot-Pulver durchzuführen und dann aus dem homogenisierten Pulver einen Graukörper zu pressen, aus dem durch Sintern oder in einem HIP-Prozess (Hot Isostatic Pressing) das Substrat 31 gebildet wird.

Ein auf diese Weise gebildetes, sehr trockenes Quarzglas zeichnet sich durch eine hohe fiktive Temperatur und somit durch eine hohe Steigung des thermischen Ausdehnungskoeffizienten des Quarzglases in der Größenordnung von über 1,8 ppb/K² bei 20°C aus. Ein geringer OH-Gehalt von weniger als 10 Gew.-ppm lässt sich aus diesem Grund auch ohne eine direkte Messung anhand der thermischen Daten des Quarzglases bzw. des Substrats 31 nachweisen. Das getrocknete Quarzglas des Substrats 31 ist in der Regel auch frei von Wasserstoff, könnte aber auch mit Wasserstoff beladen werden, ohne dass dies zu einem erhöhten OH-Gradienten führen würde.

Die weiter oben beschriebene Trocknung kann an beiden Teilkörpern 26a,b des Glaskörpers 24 gemeinsam erfolgen, es ist aber auch möglich, die Trocknung an jedem der beiden Teilkörper 26a,b einzeln durchzuführen. Es ist ggf. ausreichend, nur den oberen Teilkörper 26a sowie ggf. zusätzlich die oberen Millimeter des unteren Teilkörpers 26b zu trocknen. Zu diesem Zweck kann ein jeweiliger Teilkörper 26a, 26b einzeln oder beide Teilkörper 26a,b können gemeinsam mehrere Tage oder Wochen bei Temperaturen oberhalb von 1400°C, vorzugsweise oberhalb von 1600°C getempert werden. Bei Temperaturen oberhalb von ca. 1450°C kommt es zu nennenswerten Verformungen des Quarzglases, so dass die Trocknung in einem nach oben offenen Tiegel oder in einer nach oben offenen Form ausgeführt werden sollte.

Eine weitere Möglichkeit zur Reduzierung des durch das Heißtempern hervorgerufenen OH-Gradienten in dem Glas besteht darin, wasserstofffreies oder wasserstoffarmes Glas für die Herstellung des Substrats 31 zu verwenden. Da übliche EUV-Gläser herstellungsbedingt Wasserstoff enthalten, kann dieser vor oder ggf. während des Heißbondens gezielt aus dem Glas ausdiffundiert werden.

Fig. 6 zeigt beispielhaft für einen Glasblock bzw. Glasrohling mit einer Dicke Z₀ mehrere Verteilungen der H₂-Konzentration, die sich beim Austempern bilden, wobei davon ausgegangen wurde, dass der Glasblock anfangs einen konstanten Wert von 1 x 10¹⁴ Molekülen / cm² aufweist. Beim Austempern bilden sich zunächst Verarmungszonen an den seitlichen Rändern des Glasblocks mit einer Konzentration von 0 Molekülen / cm² unmittelbar an der Oberfläche und annähernd linearem Anstieg nach Innen und einem Plateau im mittleren Bereich. Während des Austemperns schrumpft das Plateau allmählich zusammen und erst wenn ein echter Scheitelpunkt erreicht ist, sinkt auch die Konzentration in der Mitte des Glasblocks, wodurch sich eine zusehends kleinere H₂-Konzentration in der Mitte ergibt. Der Strom des ausdiffundierenden Wasserstoffs über die Oberflächen nimmt mit der Verkleinerung des Plateaus nur geringfügig ab, da das Konzentrationsgefälle von der Konzentration in der Mitte bis zur Konzentration am Rand gleich bleibt. Daher ist zur Verminderung des Stroms des ausdiffundierenden Wasserstoffs während des Heißbondens anzustreben, beim Austempern auch die Wasserstoff-Konzentration in der Mitte des Glasblocks zu senken, beispielsweise auf 1/10 des Anfangsgehalts.

Die unterschiedliche Temperaturabhängigkeit von H2- und OH-Diffusion kann auch dahingehend ausgenutzt werden, dass die Wasserstoffkonzentration beispielsweise bei 400°C gesenkt wird, während der Großteil der OH-Ausdiffusion im Halteschritt des Bondings beispielsweise bei 1050°C stattfindet. Relativ zur Diffusionsgeschwindigkeit der OH-Gruppen ist das H2-Profil dann unterkühlt, d.h. die weiter innen liegenden hohen H2-Konzentrationen kommen nicht schnell genug nach, um die die Dissoziation von OH-Gruppen mit Wasserstoff zu versorgen. In diesem Fall ist es nicht zwingend notwendig, die H₂-Konzentration im Inneren des Glases zu senken, wenn eine H₂-Verarmungszone von mehreren mm oder wenigen cm Breite vor allem im Bereich der Kühlkanäle 25 geschaffen werden kann.

Das Austempern kann am typischerweise zylindrischen Rohglaskörper vor dem Trennen in die beiden Teilkörper 26a,b an den getrennten, aber noch unstrukturierten Teilkörpern 26a,b (d.h. ohne eingebrachte Vertiefungen), an den strukturierten Teilkörpern 26a,b oder an den beiden Teilkörpern 26a,b im bereits angesprengten Zustand erfolgen (vgl. auch Fig. 2b). Das Austempern im angesprengtem Zustand bei 200 - 400°C hat gemäß dem Artikel "Wafer direct bonding: tailoring adhesion between brittle materials", A. Plößl, G. Kräuter, Materials Science and Engineering, R25 (1999) 1-88 den Vorteil, das gleichzeitig Wasser entlang der Bondingfläche 27 ausdiffundiert, was verbesserte Bondfestigkeit, weniger Verschieben beim Aufheizen zum Heißbonden und verringerte laterale OH-Gefälle entlang des Bonds bewirkt.

Sollte wie weiter oben ausgeführt wurde die Ausdiffusion von Wasserstoff während des Heißbodens erlaubt werden, ist der Temperprozess unter Vakuum oder unter starker Spülung mit Luft oder Inertgas auszuführen, um eine Ansammlung von Wasserstoff in den Kühlkanälen 25 zu verhindern.

In dem hier beschriebenen Beispiel hat es sich als günstig erwiesen, wenn der zweite Teilkörper 26b in einem in Fig. 3a dargestellten Abstand A' vom unteren Wandabschnitt 36b des Kühlkanals 25, welcher mindestens einer Stegbreite b und bevorzugt nicht mehr als dem Zehnfachen einer Stegbreite b eines jeweiligen Steges 25 entspricht und/oder welcher zumindest der Dicke D des ersten Teilkörpers 26a und nicht mehr als dem Zehnfachen der Dicke D des ersten Teilkörpers 26a zwischen dem oberen Kanalwandabschnitt 36a und der Oberfläche 32 entspricht, einen Wasserstoff-Gehalt aufweist, der bei nicht mehr als 50% des mittleren Wasserstoff-Gehalts des zweiten Teilkörpers 26b liegt. Die Stegbreite b liegt typischerweise in der Größenordnung von mehreren Millimetern.

Eine weitere Möglichkeit, um den OH-Gradienten in dem titandotierten Quarzglas des Glaskörpers 24 bzw. des Substrats 31 zu reduzieren besteht darin, die Ausdiffusion von OH-Gruppen während des Heißbondens dadurch zu unterdrücken, dass das Heißbonden zumindest teilweise in gesättigtem Wasserdampf, in Wasser oder in einer oxidierenden Atmosphäre durchgeführt wird und/oder dass durch eine Nachbehandlung in einem sich an das Heißbonden anschließenden Temperprozess OH-Gruppen in das titandotierte Quarzglas des Glaskörpers 24 eindiffundiert werden.

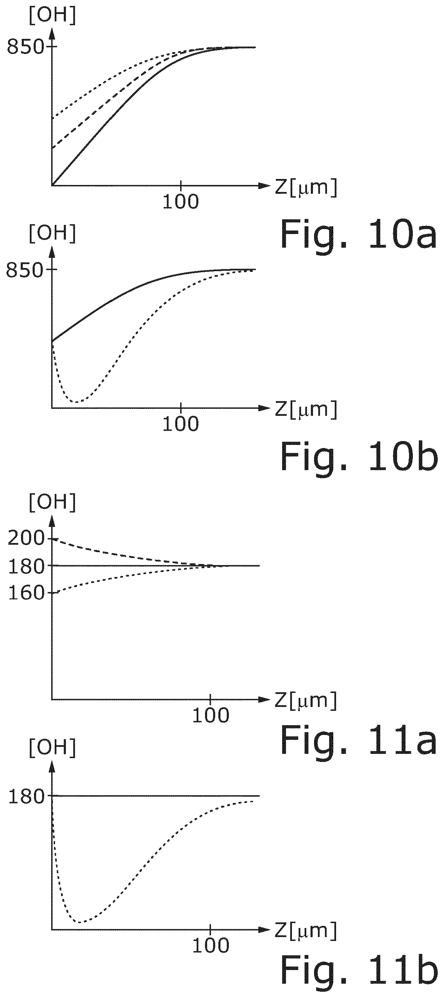

**Fig. 10a** zeigt beispielhaft den Verlauf des OH-Gehalts an einem durch Direktabscheidung hergestellten Quarzglas mit einem mittleren OH-Gehalt von ca. 850 Gew.-ppm nach einem Heißbonding-Prozess mit bei einer Haltetemperatur von 650°C und einer Haltezeit von 24 h in Dickenrichtung Z in unmittelbarer Nähe zu seiner Oberfläche. Bei dem mittleren OH-Gehalt handelt es sich im Prinzip um den maximalen OH-Gehalt des Quarzglases, da die Dicke des Bereichs, in dem diffusionsbedingt ein geringerer oder größerer OH-Gehalt als der maximale OH-Gehalt vorliegt, so gering ist, da der Beitrag dieses Bereichs bei der Mittelwertbildung über das gesamte Volumen des Glaskörpers praktisch vernachlässigbar ist. Die durchgezogene Kurve stellt den OH-Gehalt beim Heißbonden in einem inertgasgespülten Ofen dar, die gestrichelte und die punktierte Kurve stellen den OH-Gehalt beim Heißbonden in einem Ofen dar, in dem Wasserdampf mit einem Partialdruck deutlich kleiner als 100% enthalten ist. Für die gestrichelte Kurve wurde ein Partialdruck von 25% angenommen, für die punktierte Kurve wurde ein Verhältnis von 50% angenommen. Der gestrichelte und insbesondere der punktierte Verlauf des OH-Gehalts kann tolerierbar sein, so dass sich der weiter oben beschriebene Abtrag von Material von der Kanalwand 36 erübrigt oder der notwendige Abtrag zumindest reduziert werden kann.

**Fig. 10b** zeigt den OH-Gehalt in einem Glaskörper 24 aus direkt abgeschiedenem Quarzglas, bei dem der OH-Gehalt nach dem Heißbonden durch eine Nachbehandlung in Form einer auf das Heißbonden folgenden Wärmebehandlung erhöht wird. Anfänglich ergibt sich bei der Nachbehandlung die in Fig. 10b dargestellte gestrichelte Kurve, während für lange Zeiten die in Fig. 10b dargestellte durchgezogene Kurve erreicht wird.

**Fig. 11a,b** zeigen Darstellungen analog zu Fig. 10a,b für einen Glaskörper 24 aus in einem Soot-Prozess abgeschiedenen Quarzglas mit einem mittleren OH-Gehalt von ca. 180 Gew.-ppm. Die durchgezogene Kurve von Fig. 11a zeigt den Fall eines perfekt eingestellten Wasserdampf-Partialdrucks während des Heißbondens, bei dem der OH-Gehalt am Rand des Glaskörpers 24 und somit an der Kanalwand 36 praktisch nicht vom mittleren OH-Gehalt von 180 Gew.-ppm abweicht. In Fig. 11a beschreibt die gestrichelte Kurve den Fall, dass der Wasserdampf-Partialdruck zu groß gewählt wurde und die punktierte Kurve stellt den Fall dar, dass der Wasserdampf-Partialdruck zu klein gewählt wurde. Wie in Fig. 11a zu erkennen ist, weicht der OH-Gehalt am Rand des Glaskörpers 24 und somit an der Kanalwand 36 auch in diesen beiden Fällen um nicht mehr als 10% (entsprechend ± 18 Gew.-ppm) vom mittleren OH-Gehalt des Substrats 31 bzw. des Glaskörpers 24 ab. Der Punkt, an dem die Abweichung vom durchschnittlichen OH-Gehalt ggf. bei mehr als 10% liegt, hängt dabei von der Bonding-Temperatur und der Bonding-Dauer ab.

Fig. 11b zeigt als gestrichelte Kurve den OH-Gehalt eines vollständig trocken gebondeten Quarzglaskörpers 24 kurz nach dem Beginn der Nachbehandlung und als durchgezogene Kurve den OH-Gehalt nach sehr langer Zeit bei ideal eingestelltem Partialdruck des Wasserdampfs. Wie anhand der durchgezogenen Kurve zu erkennen ist, ergibt sich auch in diesem Fall eine Verteilung des OH-Gehalts, die praktisch nicht vom mittleren OH-Gehalt von ca. 180 Gew.-ppm abweicht.

Für einen Quarzglaskörper 24 aus direkt abgeschiedenem Quarzglas ergeben sich analoge Kurven für die Verteilung des OH-Gehalts, wenn Partialdrücke von Wasserdampf nahe 100% bzw. entsprechend der Löslichkeit bei der jeweiligen Temperatur verwendet werden.

Bei den in Fig. 10a und in Fig. 11a beschriebenen Heißbonding-Prozessen ist es in der Regel sinnvoll, den Bonding-Prozess trocken zu beginnen, damit Oberflächenwasser und ggf. Kondenswasser aus dem Glaskörper ausdiffundieren können, bevor der Wasserdampf zugegeben wird. Alternativ kann für die Verringerung der Ausdiffusion der Heißbonding-Prozess in Wasser oder in einer oxidierenden Atmosphäre durchgeführt werden.

Bei den weiter oben beschriebenen Beispielen wurde von einem Glaskörper 24 in Form von titandotiertem Quarzglas ausgegangen. Die dort beschriebenen Maßnahmen bzw. Erkenntnisse lassen sich aber auch auf einen Glaskörper 24 aus undotiertem Quarzglas anwenden bzw. übertragen, welches bei reflektierenden optischen Elementen für andere Wellenlängenbereiche, z.B. für den UV-Wellenlängenbereich, zum Einsatz kommt. Dies trifft - zumindest teilweise - auch auf einem Glaskörper 24 aus Glaskeramiken zu.

## Patentansprüche

1. Optisches Element (M2) zur Reflexion von Strahlung, insbesondere zur Reflexion von EUV-Strahlung (16), umfassend:
ein Substrat (31), das aus Quarzglas, insbesondere aus titandotiertem Quarzglas, oder aus einer Glaskeramik gebildet ist und das einen ersten Teilkörper (26a) und einen zweiten Teilkörper (26b) umfasst, die entlang einer Bondingfläche (27) durch Heißbonden zusammengefügt sind,
eine Mehrzahl von Kühlkanälen (25), die in dem Substrat (31) im Bereich der Bondingfläche (27) verlaufen und durch Stege (35) voneinander getrennt sind, sowie
eine reflektierende Beschichtung (33), die auf eine Oberfläche (32) des ersten Teilkörpers (26a) aufgebracht ist,
**dadurch gekennzeichnet,**
**dass** ein jeweiliger Kühlkanal (25) eine Kanalwand (36) aufweist, die an mindestens einer an einen jeweiligen Steg (35) angrenzenden Position (Ps), insbesondere in einem gesamten an den jeweiligen Steg (35) angrenzenden seitlichen Wandabschnitt (36c,d), eine Nulldurchgangstemperatur (Tzc,s) aufweist, die um weniger als 3,0 K, bevorzugt um weniger als 2,0 K, insbesondere um weniger als 1,0 K von einer Nulldurchgangstemperatur (T_{ZC,M}) an einer Stegmitte (M) des Stegs (35) abweicht, und dass die Kanalwand (36) an der mindestens einen an den Steg (35) angrenzenden Position (Ps), insbesondere im gesamten seitlichen Wandabschnitt (36c,d), und/oder an der mindestens einen der Oberfläche (32) zugewandten Position (P_{D}), insbesondere im gesamten oberen Wandabschnitt (36a), einen OH-Gehalt ([OH]) aufweist, der größer als 60 Gew.-ppm, insbesondere größer als 120 Gew.-ppm ist.

2. Optisches Element nach Anspruch 1, bei dem die Kanalwand (36) an mindestens einer der Oberfläche (32), auf welche die reflektierende Beschichtung (33) aufgebracht ist, zugewandten Position (P_{D}), insbesondere in einem gesamten der Oberfläche (32) zugewandten oberen Wandabschnitt (36a), eine Nulldurchgangstemperatur (T_{ZC,D}) aufweist, die um weniger als 3,0 K, bevorzugt um weniger als 2,0 K, insbesondere um weniger als 1,0 K von einer Nulldurchgangstemperatur (Tzc,o) an der Oberfläche (32) abweicht.

3. Optisches Element nach dem Oberbegriff von Anspruch 1, insbesondere nach Anspruch 1 oder 2, **dadurch gekennzeichnet, dass** ein jeweiliger Kühlkanal (25) eine Kanalwand (36) aufweist, die an mindestens einer an einen jeweiligen Steg (35) angrenzenden Position (Ps), insbesondere in einem gesamten an den jeweiligen Steg (35) angrenzenden seitlichen Wandabschnitt (36c,d), einen OH-Gehalt ([OH]) aufweist, der um nicht mehr als 60 Gew.-ppm, bevorzugt um nicht mehr als 30 Gew.-ppm, insbesondere um nicht mehr als 20 Gew.-ppm von einem OH-Gehalt ([OH]) an einer Stegmitte (M) des jeweiligen Stegs (35) abweicht.

4. Optisches Element nach Anspruch 3, bei dem die Kanalwand (36) an mindestens einer der Oberfläche (32), auf welche die reflektierende Beschichtung (33) aufgebracht ist, zugewandten Position (P_{D}), insbesondere in einem gesamten der Oberfläche (32) zugewandten oberen Wandabschnitt (36a) einen OH-Gehalt ([OH]) aufweist, der um nicht mehr als 60 Gew.-ppm, bevorzugt um nicht mehr als 30 Gew.-ppm, insbesondere um nicht mehr als 20 Gew.-ppm von einem OH-Gehalt ([OH]) an der Oberfläche (32) abweicht.

5. Optisches Element nach einem der Ansprüche 3 oder 4, bei dem ein an die Kanalwand (36) angrenzender Verarmungsbereich (30), an dem der OH-Gehalt ([OH]) des Substrats (31) um mindestens 5 Gew.-ppm kleiner ist als der OH-Gehalt ([OH]) an der Stegmitte (M) des jeweiligen Stegs (35) und/oder an der Oberfläche (32) eine Dicke (d) von weniger als 50 µm, bevorzugt von weniger als 30 µm, insbesondere von weniger als 1 µm aufweist.

6. Optisches Element nach einem der vorhergehenden Ansprüche, bei dem ein OH-Gehalt ([OH]) an der Kanalwand (26) um weniger als 10 %, bevorzugt um weniger als 5 %, insbesondere um weniger als 1 % von einem mittleren OH-Gehalt ([OH]) im Volumen des Substrats (31) abweicht.

7. Optisches Element nach einem der vorhergehenden Ansprüche, bei dem die Kanalwand (36) zumindest teilweise, insbesondere vollständig von einer bevorzugt metallischen Schutzbeschichtung (38) bedeckt ist.

8. Optisches Element nach Anspruch 7, bei dem die Kanalwand (36) eine Mehrzahl von Eckbereichen (39a-d) aufweist und die Kanalwand (36) nur außerhalb der Eckbereiche (39a-d) von der Schutzbeschichtung (38) bedeckt ist.

9. Optisches Element nach Anspruch 7 oder 8, bei dem die Kanalwand (36) entlang von sich in Längsrichtung (Y) des Kühlkanals (25) erstreckenden, bevorzugt schräg zur Längsrichtung (Y) verlaufenden Schlitzen (40) nicht von der Schutzbeschichtung (38) bedeckt ist.

10. Optisches Element nach einem der vorhergehenden Ansprüche, bei dem der erste Teilkörper (26a), insbesondere das Substrat (31), einen maximalen Wasserstoff-Gehalt ([H₂]) von nicht mehr als 1 x 10¹⁵ Molekülen / cm³, bevorzugt von nicht mehr als 1 x 10¹⁴ Molekülen / cm³ aufweist.

11. Optisches Element nach Anspruch 10, bei dem der zweite Teilkörper (26b) in einem Abstand (A') von einem unteren Wandabschnitt (36b) des Kühlkanals (25), welcher mindestens einer Stegbreite (b) und bevorzugt nicht mehr als dem Zehnfachen einer Stegbreite (b) eines jeweiligen Steges (25) entspricht und/oder welcher zumindest der Dicke (D) des ersten Teilkörpers (26a) und nicht mehr als dem Zehnfachen der Dicke (D) des ersten Teilkörpers (26a) zwischen dem oberen Kanalwandabschnitt (36a) und der Oberfläche (32) entspricht, einen Wasserstoff-Gehalt ([H₂]) aufweist, der bei nicht mehr als 50% des mittleren Wasserstoff-Gehalts ([H₂]) des zweiten Teilkörpers (26b) liegt.

12. Optische Anordnung, insbesondere EUV-Lithographiesystem (1), umfassend: mindestens ein optisches Element (M2) nach einem der vorhergehenden Ansprüche, sowie
eine Kühleinrichtung (37), die zum Durchströmen der Mehrzahl von Kühlkanälen (25) mit einer Kühlflüssigkeit ausgebildet ist.

## Claims

1. Optical element (M2) for reflecting radiation, in particular for reflecting EUV radiation (16), comprising:
a substrate (31) formed from quartz glass, especially from titanium-doped quartz glass, or from a glass ceramic, and comprising a first portion (26a) and a second portion (26b) that are joined along a bonding face (27) by high-temperature bonding,
a multitude of cooling channels (25) that run within the substrate (31) in the region of the bonding face (27) and are separated from one another by lands (35), and
a reflective coating (33) applied to a surface (32) of the first portion (26a),
**characterized**
**in that** a particular cooling channel (25) has a channel wall (36) which, at at least one position (P_{S}) adjoining a particular land (35), especially over an entire lateral wall section (36c,d) that adjoins the particular land (35), has a zero crossing temperature (T_{ZC,S}) that varies by less than 3.0 K, preferably by less than 2.0 K, especially by less than 1.0 K, from a zero crossing temperature (T_{ZC,M}) at a middle (M) of the land (35), and in that said channel wall (36), at said at least one position (P_{S}) adjoining said land (35), especially over said entire lateral wall section (36c,d), and/or at the at least one position (P_{D}) facing the surface (32), especially over the entire upper wall section (36a), has an OH content ([OH]) of greater than 60 ppm by weight, especially greater than 120 ppm by weight.

2. Optical element according to Claim 1, in which the channel wall (36) at at least one position (P_{D}) facing the surface (32) to which the reflective coating (33) has been applied, especially over an entire upper wall section (36a) facing the surface (32), has a zero crossing temperature (T_{ZC,D}) that varies by less than 3.0 K, preferably by less than 2.0 K, especially by less than 1.0 K, from a zero crossing temperature (T_{ZC,O}) at the surface (32).

3. Optical element according to the preamble of Claim 1, especially according to Claim 1 or 2, **characterized in that** a particular cooling channel (25) has a channel wall (36) which, at at least one position (P_{S}) adjoining a particular land (35), especially over an entire lateral wall section (36c,d) adjoining the particular land (35), has an OH content ([OH]) that varies by not more than 60 ppm by weight, preferably by not more than 30 ppm by weight, especially by not more than 20 ppm by weight, from an OH content ([OH]) at a middle (M) of the particular land (35).

4. Optical element according to Claim 3, in which the channel wall (36) at at least one position (P_{D}) facing the surface (32) to which the reflective coating (33) has been applied, especially over an entire upper wall section (36a) facing the surface (32), has an OH content ([OH]) that varies by not more than 60 ppm by weight, preferably by not more than 30 ppm by weight, especially by not more than 20 ppm by weight, from an OH content ([OH]) at the surface (32).

5. Optical element according to either of Claims 3 and 4, in which a depletion region (30) adjoining the channel wall (36) in which the OH content ([OH]) of the substrate (31) is at least 5 ppm by weight lower than the OH content ([OH]) in the middle (M) of the particular land (35) and/or at the surface (32) has a thickness (d) of less than 50 µm, preferably of less than 30 µm, especially of less than 1 µm.

6. Optical element according to any of the preceding claims, in which an OH content ([OH]) at the channel wall (26) varies by less than 10%, preferably by less than 5%, especially by less than 1%, from an average OH content ([OH]) in the bulk of the substrate (31).

7. Optical element according to any of the preceding claims, in which the channel wall (36) is covered at least partly, especially completely, by a preferably metallic protective coating (38).

8. Optical element according to Claim 7, in which the channel wall (36) has a multitude of corner regions (39a-d) and the channel wall (36) is covered by the protective coating (38) only outside the corner regions (39a-d).

9. Optical element according to Claim 7 or 8, in which the channel wall (36) is not covered by the protective coating (38) along slots (40) that extend in longitudinal direction (Y) of the cooling channel (25), preferably obliquely to longitudinal direction (Y).

10. Optical element according to any of the preceding claims, in which the first portion (26a), especially the substrate (31), has a maximum hydrogen content ([H₂]) of not more than 1 x 10¹⁵ molecules/cm³, preferably of not more than 1 x 10¹⁴ molecules/cm³.

11. Optical element according to Claim 10, in which the second portion (26b), at a distance (A') from a lower wall section (36b) of the cooling channel (25) which corresponds at least to a land width (b) and preferably to not more than ten times a land width (b) of a particular land (25) and/or which corresponds at least to the thickness (D) of the first portion (26a) and to not more than ten times the thickness (D) of the first portion (26a) between the upper channel wall section (36a) and the surface (32), has a hydrogen content ([H₂]) which is not more than 50% of the average hydrogen content ([H₂]) of the second portion (26b).

12. Optical arrangement, in particular EUV lithography system (1), comprising: at least one optical element (M2) according to one of the preceding claims, and
a cooling device (37) designed for flow of a cooling liquid through the multitude of cooling channels (25).

## Revendications

1. Élément optique (M2) destiné à la réflexion d'un rayonnement, en particulier à la réflexion d'un rayonnement UVE (16), comprenant :
un substrat (31) constitué de verre de quartz, en particulier de verre de quartz dopé au titane, ou de vitrocéramique, et comprenant un premier corps partiel (26a) et un second corps partiel (26b) qui sont assemblés le long d'une surface de liaison (27) par liaison à chaud, une pluralité de canaux de refroidissement (25) qui s'étendent dans le substrat (31) dans la zone de la surface de liaison (27) et sont séparés les uns des autres par des entretoises (35),
ainsi qu'un revêtement réfléchissant (33) qui est appliqué sur une surface (32) du premier corps partiel (26a),
**caractérisé**
**en ce qu'**un canal de refroidissement (25) respectif présente une paroi de canal (36) qui présente une température de passage au point zéro (T_{ZC,S}) à au moins une position (P_{S}) adjacente à une entretoise (35) respective, en particulier dans toute une section de paroi latérale (36c,d) adjacente à l'entretoise (35) respective, qui s'écarte de moins de 3,0 K, de préférence de moins de 2,0 K, en particulier de moins de 1,0 K, d'une température de passage au point zéro (T_{ZC,M}) au niveau du centre d'entretoise (M) de l'entretoise (35), et en ce que la paroi de canal (36) au niveau de l'au moins une position (P_{S}) adjacente à l'entretoise (35), en particulier dans toute la section de paroi latérale (36c,d), et/ou au niveau de l'au moins une position (P_{D}) faisant face à la surface (32), en particulier dans toute la section de paroi supérieure (36a), présente une teneur en OH ([OH]) supérieure à 60 ppm en poids, en particulier supérieure à 120 ppm en poids.

2. Élément optique selon la revendication 1, dans lequel la paroi de canal (36) présente une température de passage au point zéro (T_{ZC,D}) à au moins une position (P_{D}) faisant face à la surface (32) sur laquelle est appliqué le revêtement réfléchissant (33), en particulier dans toute une section de paroi supérieure (36a) faisant face à la surface (32), qui s'écarte de moins de 3,0 K, de préférence de moins de 2,0 K, en particulier de moins de 1,0 K d'une température de passage au point zéro (T_{ZC,O}) au niveau de la surface (32).

3. Élément optique selon le préambule de la revendication 1, en particulier selon la revendication 1 ou 2, **caractérisé en ce qu'**un canal de refroidissement (25) respectif présente une paroi de canal (36) qui, à au moins une position (P_{S}) adjacente à une entretoise (35) respective, en particulier dans toute une section de paroi latérale (36c,d) adjacente à l'entretoise (35) respective, présente une teneur en OH ([OH]) qui ne s'écarte pas de plus de 60 ppm en poids, de préférence de plus de 30 ppm en poids, en particulier, de plus de 20 ppm en poids d'une teneur en OH ([OH]) au niveau d'un centre d'entretoise (M) de l'entretoise (35) respective.

4. Élément optique selon la revendication 3, dans lequel la paroi de canal (36) présente une teneur en OH ([OH]) à au moins une position (P_{D}) faisant face à la surface (32) sur laquelle est appliqué le revêtement réfléchissant (33), en particulier dans toute une section de paroi supérieure (36a) faisant face à la surface (32), qui ne s'écarte pas de plus de 60 ppm en poids, de préférence de plus de 30 ppm en poids, en particulier de plus de 20 ppm en poids d'une teneur en OH ([OH]) au niveau de la surface (32).

5. Élément optique selon l'une quelconque des revendications 3 et 4, dans lequel une zone d'appauvrissement (30) adjacente à la paroi de canal (36), au niveau de laquelle la teneur en OH ([OH]) du substrat (31) est inférieure d'au moins 5 ppm en poids à la teneur en OH ([OH]) au niveau du centre d'entretoise (M) de l'entretoise (35) respective et/ou au niveau de la surface (32), présente une épaisseur (d) de moins de 50 µm, de préférence de moins de 30 µm, en particulier de moins de 1 µm.

6. Élément optique selon l'une quelconque des revendications précédentes, dans lequel une teneur en OH ([OH]) au niveau de la paroi de canal (26) s'écarte de moins de 10 %, de préférence de moins de 5 %, en particulier de moins de 1 %, d'une teneur en OH moyenne ([OH]) dans le volume du substrat (31).

7. Élément optique selon l'une quelconque des revendications précédentes, dans lequel la paroi de canal (36) est revêtue au moins partiellement, en particulier complètement, d'une couche de protection (38) de préférence métallique.

8. Élément optique selon la revendication 7, dans lequel la paroi de canal (36) présente une pluralité de zones d'angle (39a-d) et la paroi de canal (36) est revêtue du revêtement de protection (38) uniquement en dehors des zones d'angle (39a-d).

9. Élément optique selon la revendication 7 ou 8, **caractérisé en ce que** la paroi de canal (36) n'est pas revêtue du revêtement de protection (38) le long de fentes (40) s'étendant dans la direction longitudinale (Y) du canal de refroidissement (25) et s'étendant de préférence obliquement par rapport à la direction longitudinale (Y).

10. Élément optique selon l'une quelconque des revendications précédentes, dans lequel le premier corps partiel (26a), en particulier le substrat (31), présente une teneur maximale en hydrogène ([H₂]) qui n'est pas supérieure à 1 x 10¹⁵ molécules/cm³, de préférence qui n'est pas supérieure à 1 x 10¹⁴ molécules/cm³.

11. Élément optique selon la revendication 10, dans lequel le second corps partiel (26b) présente, en deçà d'une distance (A') d'une section de paroi inférieure (36b) du canal de refroidissement (25), laquelle correspond à au moins une largeur d'entretoise (b) et de préférence pas à plus de dix fois une largeur d'entretoise (b) d'une entretoise (25) respective et/ou qui correspond au moins à l'épaisseur (D) du premier corps partiel (26a) et pas à plus de dix fois l'épaisseur (D) du premier corps partiel (26a) entre la partie de paroi de canal supérieure (36a) et la surface (32), une teneur en hydrogène ([H₂]) qui n'est pas supérieure à 50 % de la teneur en hydrogène moyenne ([H₂]) du second corps partiel (26b).

12. Dispositif optique, en particulier système de lithographie UVE (1), comprenant : au moins un élément optique (M2) selon l'une quelconque des revendications précédentes, et
un dispositif de refroidissement (37) qui est conçu pour permettre à un liquide de refroidissement de s'écouler à travers la pluralité de canaux de refroidissement (25).
